# EUROPEAN PATENT APPLICATION

(11) **EP 4 604 430 A1**
(43) Date of publication of application: **20.08.2025**
(21) Application number: 23915704.3
(22) Date of filing: 14.11.2023
(51) Int. Cl.: H04L 1/00

(54) **DATA TRANSMISSION METHOD AND APPARATUS, SYSTEM, AND COMPUTER-READABLE STORAGE MEDIUM**

(30) Priority: 10.01.2023 CN 202310037983
(71) Applicant: Huawei Technologies Co., Ltd., Shenzhen, Guangdong 518129 (CN)
(72) Inventor: REN, Hao, Shenzhen, Guangdong 518129 (CN); HE, Xiang, Shenzhen, Guangdong 518129 (CN); WANG, Xinyuan, Shenzhen, Guangdong 518129 (CN)
(74) Representative: Huawei European IPR
(86) International application number: PCT/CN2023/131616
(87) International publication number: WO 2024/148946

(57) **Abstract**

This application discloses a data transmission method and apparatus, a system, and a computer-readable storage medium, and relates to the field of communication technologies. The method includes: A first module performs convolutional interleaving on symbols included in a plurality of obtained first codewords, to obtain an interleaving result, where the first codeword is a codeword obtained by encoding first data by using a first FEC code; obtains, based on the interleaving result, second data that includes identification information, and transmits the second data to a second module. The convolutional interleaving is performed on the symbols included in the plurality of first codewords, so that when burst errors occur in the second data subsequently, the burst errors are dispersed onto a plurality of symbols, to reduce a BER of the second data after error correction. If the second data includes a second codeword, the identification information includes codeword boundary information of the second codeword, and no additional data needs to be inserted as the identification information, so that data transmission costs are low.

## Description

This application claims priority to Chinese Patent Application No. 202310037983.5, filed on January 10, 2023 and entitled "DATA TRANSMISSION METHOD AND APPARATUS, SYSTEM, AND COMPUTER-READABLE STORAGE MEDIUM", which is incorporated herein by reference in its entirety.

### TECHNICAL FIELD

This application relates to the field of communication technologies, and in particular, to a data transmission method and apparatus, a system, and a computer-readable storage medium.

### BACKGROUND

With the development of communication technologies, data is encoded at a transmitting end of the data based on a forward error correction (forward error correction, FEC) code, and received data is decoded at a receiving end of the data by using the same FEC code. This becomes a widely used data transmission manner. In a decoding process, the receiving end of the data performs error correction on the received data, to correct bit errors (bit error) in the data. Because distribution of the bit errors in the data varies, when bit error rates (bit error rate, BER) before the error correction are the same, BERs after the error correction may be different.

For example, based on the distribution, the bit errors include random errors (random error) and non-random errors (non-random error), and the non-random errors are that a plurality of bit errors concentratedly occur in a short data sequence. Usually, based on the same BERs before the error correction, the non-random errors cause a higher BER that is after the error correction than the random errors. Therefore, a data transmission method in which based on FEC, data locations are adjusted in an interleaving manner at the transmitting end of the data, and the data locations are restored in a de-interleaving manner at the receiving end of the data is needed, so that distribution of the non-random errors is close to that of the random errors after the de-interleaving, to reduce the BER after the error correction.

### SUMMARY

This application provides a data transmission method and apparatus, a system, and a computer-readable storage medium, to implement data transmission based on FEC in combination with convolutional interleaving.

According to a first aspect, a data transmission method is provided. The method includes: A first module performs convolutional interleaving on symbols included in a plurality of obtained first codewords, to obtain an interleaving result, where the first codeword is a codeword obtained by encoding first data by using a first FEC code. Then, the first module obtains, based on the interleaving result, second data that includes identification information, and transmits the second data to a second module. If the second data includes a second codeword, the identification information includes codeword boundary information of the second codeword.

In the method, the convolutional interleaving is performed on the symbols included in the plurality of first codewords, so that when burst errors occur in the second data subsequently, the burst errors are dispersed onto a plurality of symbols, to reduce a BER of the second data after error correction. In addition, if the second data includes the second codeword, the identification information is the codeword boundary information of the second codeword, and no additional identification information indicating a start interleaving location at which the convolutional interleaving is performed on the symbols included in the plurality of first codewords needs to be inserted, so that data transmission costs are low, applicability to a data transmission scenario in which bandwidth or a frequency of a phase-locked loop is limited is high, and implementation complexity of a data transmission system used to perform the method is low.

In a possible implementation, the performing convolutional interleaving on symbols included in a plurality of obtained first codewords, to obtain an interleaving result includes: inputting the symbols included in the plurality of first codewords into a plurality of first delay units of a convolution interleaver, performing, via the plurality of first delay units, convolutional interleaving on the symbols that are included in the plurality of first codewords and that are obtained through round robin, to obtain a plurality of first bit groups that are output by the plurality of first delay units through round robin, and using, as the interleaving result, the plurality of first bit groups that are output by the plurality of first delay units through round robin, where one first bit group includes symbols that are output by the plurality of first delay units through round robin for one time. In the method, in a process of obtaining the interleaving result through the convolutional interleaving, the convolutional interleaving is performed on the symbols included in the plurality of first codewords, and no additional data is introduced. Therefore, an amount of data for performing convolutional interleaving is small, and efficiency of the convolutional interleaving is high.

In a possible implementation, the interleaving result includes n first bit groups that are output by the plurality of first delay units through round robin for n times, and the obtaining, based on the interleaving result, second data that includes identification information includes: encoding, based on a second FEC code, the n first bit groups that are output by the plurality of first delay units through round robin for n times, to obtain m second codewords, and obtaining the second data based on the m second codewords, where a quantity of bits corresponding to the n first bit groups is equal to a quantity of bits included in information bits of the m codewords of the second FEC code, both m and n are positive integers, and m is less than or equal to n.

In the implementation, the n first bit groups are encoded based on the second FEC code, to obtain the m second codewords, so that a receiving end can obtain, by obtaining the codeword boundary information of the second codeword, the start interleaving location at which the convolutional interleaving is performed on the symbols included in the plurality of first codewords, and then perform convolutional de-interleaving based on the start interleaving location. Because no additional identification information needs to be inserted, the data transmission costs of the implementation are low, and the applicability to the data transmission scenario in which the bandwidth or the frequency of the phase-locked loop is limited is high.

In a possible implementation, the second data does not include the second codeword, the interleaving result includes n first bit groups that are output by the plurality of first delay units through round robin for n times, and the obtaining, based on the interleaving result, second data that includes identification information includes: obtaining k target data frames based on a format of a reference data frame and the n first bit groups that are output by the plurality of first delay units through round robin for n times, and obtaining the second data based on the k target data frames, where the target data frame includes frame synchronization information, the frame synchronization information is used as the identification information, a quantity of bits corresponding to the n first bit groups is less than or equal to a quantity of bits included in the k target data frames, both k and n are positive integers, and k is less than or equal to n. If the second data does not include the second codeword, it means that the method is applicable to a non-cascaded encoding scenario, and an application scenario of the method is flexible.

In a possible implementation, the second data does not include the second codeword, and the performing convolutional interleaving on symbols included in a plurality of obtained first codewords, to obtain an interleaving result includes: inputting at least one piece of identification information and the symbols included in the plurality of first codewords into a plurality of first delay units of a convolution interleaver, performing, via the plurality of first delay units, convolutional interleaving on the at least one piece of identification information that is obtained through round robin and the symbols that are included in the plurality of first codewords and that are obtained through round robin, to obtain a plurality of second bit groups that are output by the plurality of first delay units through round robin, and using, as the interleaving result, the plurality of second bit groups that are output by the plurality of first delay units through round robin, where at least one second bit group includes symbols that are output by the plurality of first delay units through round robin for one time, or at least one second bit group includes identification information and symbols that are output by the plurality of first delay units through round robin for one time, and the identification information indicates the start interleaving location at which the convolutional interleaving is performed on the symbols included in the plurality of first codewords. If the interleaving result is obtained in the implementation, a specific form of the identification information may be set based on experience or an actual requirement, provided that the identification information can indicate the start interleaving location at which the convolutional interleaving is performed on the symbols included in the plurality of first codewords. A type of the identification information is flexible.

In a possible implementation, the start interleaving location at which the convolutional interleaving is performed on the symbols included in the plurality of first codewords is in any one of the plurality of first delay units, and the start interleaving location is flexible.

In a possible implementation, the symbols included in the plurality of first codewords are input into the plurality of first delay units of the convolution interleaver in a manner of a first data stream, a transmission rate of the first data stream is greater than or equal to 100 gigabits per second (gigabits per second, Gbps), and the symbols included in the plurality of first codewords are input into the plurality of first delay units of the convolution interleaver at a high rate.

In a possible implementation, the first data stream is transmitted to the plurality of first delay units of the convolution interleaver through at least one lane of an attachment unit interface (attachment unit interface, AUI), and a transmission manner of the first data stream is flexible.

According to a second aspect, a data transmission method is provided. The method includes: A second module receives second data that includes identification information and that is transmitted by a first module, where the second data is obtained based on an interleaving result obtained by performing convolutional interleaving on symbols included in a plurality of first codewords, the first codeword is a codeword obtained by encoding first data by using a first FEC code, and if the second data includes a second codeword, the identification information includes codeword boundary information of the second codeword, obtains, based on the identification information, to-be-de-interleaved data in the second data and a start interleaving location at which the convolutional interleaving is performed on the symbols included in the plurality of first codewords; and performs convolutional de-interleaving on the to-be-de-interleaved data based on the start interleaving location, to obtain the plurality of first codewords.

In the method, because the second data is obtained based on the interleaving result obtained by performing convolutional interleaving on the symbols included in the plurality of first codewords, when burst errors occur in the second data, the burst errors are dispersed onto a plurality of symbols, to reduce a BER of the second data after error correction. In addition, if the second data includes the second codeword, the identification information is the codeword boundary information of the second codeword, and no additional identification information indicating the start interleaving location at which the convolutional interleaving is performed on the symbols included in the plurality of first codewords needs to be inserted into the second data, so that data transmission costs are low, applicability to a data transmission scenario in which bandwidth or a frequency of a phase-locked loop is limited is high, and implementation complexity of a data transmission system used to perform the method is low.

In a possible implementation, the obtaining, based on the identification information, to-be-de-interleaved data in the second data and a start interleaving location at which the convolutional interleaving is performed on the symbols included in the plurality of first codewords includes: obtaining, based on the codeword boundary information of the second codeword, at least one second codeword included in the second data, obtaining a start location of the at least one second codeword, using the start location as the start interleaving location at which the convolutional interleaving is performed on the symbols included in the plurality of first codewords, and decoding the at least one second codeword to obtain the to-be-de-interleaved data. The implementation is applicable to a cascaded encoding scenario.

In a possible implementation, if the second data does not include the second codeword, the identification information is frame synchronization information, and the obtaining, based on the identification information, to-be-de-interleaved data in the second data and a start interleaving location at which the convolutional interleaving is performed on the symbols included in the plurality of first codewords includes: obtaining, based on the frame synchronization information, at least one target data frame included in the second data, obtaining a start location of frame data of the at least one target data frame, using the start location as the start interleaving location at which the convolutional interleaving is performed on the symbols included in the plurality of first codewords, and using, as the to-be-de-interleaved data, the frame data included in the at least one target data frame. The implementation is applicable to a non-cascaded encoding scenario in which the second data includes the target data frame.

In a possible implementation, the to-be-de-interleaved data includes a plurality of third bit groups, one third bit group includes symbols that are of the first codewords and that are output by a plurality of first delay units of a convolution interleaver through round robin for one time, and the performing convolutional de-interleaving on the to-be-de-interleaved data based on the start interleaving location, to obtain the plurality of first codewords includes: obtaining a start de-interleaving location that corresponds to the start interleaving location and that is in a plurality of second delay units of a convolution de-interleaver, inputting, at the start de-interleaving location, the plurality of third bit groups into the plurality of second delay units, performing, via the plurality of second delay units, convolutional de-interleaving on symbols that are included in the plurality of third bit groups and that are obtained through round robin, obtaining the symbols that are included in the plurality of first codewords and that are output by the plurality of second delay units through round robin, and obtaining the plurality of first codewords based on the symbols included in the plurality of first codewords. In the implementation, the third bit group does not include the identification information, and efficiency of performing convolutional de-interleaving is high.

In a possible implementation, if the second data does not include the second codeword, the identification information indicates the start interleaving location at which the convolutional interleaving is performed on the symbols included in the plurality of first codewords, and the obtaining, based on the identification information, to-be-de-interleaved data in the second data and a start interleaving location at which the convolutional interleaving is performed on the symbols included in the plurality of first codewords includes: obtaining the start interleaving location that is indicated by the identification information and at which the convolutional interleaving is performed on the symbols included in the plurality of first codewords, and using data at the start interleaving location and data after the start interleaving location that are in the second data as the to-be-de-interleaved data. The implementation is applicable to a non-cascaded encoding scenario in which the second data does not include a target data frame.

In a possible implementation, the to-be-de-interleaved data includes a plurality of fourth bit groups; at least one fourth bit group includes symbols that are of the first codewords and that are output by a plurality of first delay units of a convolution interleaver through round robin for one time, or at least one fourth bit group includes identification information and symbols that are output by a plurality of first delay units through round robin for one time; and the performing convolutional de-interleaving on the to-be-de-interleaved data based on the start interleaving location, to obtain the plurality of first codewords includes: obtaining a start de-interleaving location that corresponds to the start interleaving location and that is in a plurality of second delay units of a convolution de-interleaver, inputting, at the start de-interleaving location, the plurality of fourth bit groups into the plurality of second delay units, performing, via the plurality of second delay units, convolutional de-interleaving on symbols that are included in the plurality of fourth bit groups and that are obtained through round robin or on identification information and symbols that are included in the plurality of fourth bit groups and that are obtained through round robin, obtaining the symbols included in the plurality of first codewords and the identification information that are output by the plurality of second delay units through round robin, and obtaining the plurality of first codewords based on the symbols included in the plurality of first codewords. The implementation is applicable to performing convolutional de-interleaving on the fourth bit group including the identification information.

In a possible implementation, the start de-interleaving location is in any one of the plurality of second delay units, and the start de-interleaving location is flexible.

In a possible implementation, the plurality of second delay units of the convolution de-interleaver output, in a manner of a second data stream, the symbols included in the plurality of first codewords, and a transmission rate of the second data stream is greater than or equal to 100 Gbps. The plurality of second delay units output, at a high rate, the symbols included in the plurality of first codewords.

In a possible implementation, the plurality of second delay units of the convolution de-interleaver output the second data stream through at least one lane of an AUI, and a transmission manner of the second data stream is flexible.

According to a third aspect, a data transmission apparatus is provided. The apparatus is used in a first module, and the apparatus includes:
an interleaving unit, configured to perform convolutional interleaving on symbols included in a plurality of obtained first codewords, to obtain an interleaving result, where the first codeword is a codeword obtained by encoding first data by using a first FEC code;
an obtaining unit, configured to obtain, based on the interleaving result, second data that includes identification information, where if the second data includes a second codeword, the identification information includes codeword boundary information of the second codeword; and
a transmission unit, configured to transmit the second data to a second module.

In a possible implementation, the interleaving unit is configured to: input the symbols included in the plurality of first codewords into a plurality of first delay units of a convolution interleaver; perform, via the plurality of first delay units, convolutional interleaving on the symbols that are included in the plurality of first codewords and that are obtained through round robin, to obtain a plurality of first bit groups that are output by the plurality of first delay units through round robin, where one first bit group includes symbols that are output by the plurality of first delay units through round robin for one time; and use, as the interleaving result, the plurality of first bit groups that are output by the plurality of first delay units through round robin.

In a possible implementation, the interleaving result includes n first bit groups that are output by the plurality of first delay units through round robin for n times, and the obtaining unit is configured to: encode, based on a second FEC code, the n first bit groups that are output by the plurality of first delay units through round robin for n times, to obtain m second codewords, where a quantity of bits corresponding to the n first bit groups is equal to a quantity of bits included in information bits of the m codewords of the second FEC code, both m and n are positive integers, and m is less than or equal to n; and obtain the second data based on the m second codewords.

In a possible implementation, the second data does not include the second codeword, the interleaving result includes n first bit groups that are output by the plurality of first delay units through round robin for n times, and the obtaining unit is configured to: obtain k target data frames based on a format of a reference data frame and the n first bit groups that are output by the plurality of first delay units through round robin for n times, where the target data frame includes frame synchronization information, the frame synchronization information is used as the identification information, a quantity of bits corresponding to the n first bit groups is less than or equal to a quantity of bits included in the k target data frames, both k and n are positive integers, and k is less than or equal to n; and obtain the second data based on the k target data frames.

In a possible implementation, the second data does not include the second codeword, and the interleaving unit is configured to: input at least one piece of identification information and the symbols included in the plurality of first codewords into a plurality of first delay units of a convolution interleaver; perform, via the plurality of first delay units, convolutional interleaving on the at least one piece of identification information that is obtained through round robin and the symbols that are included in the plurality of first codewords and that are obtained through round robin, to obtain a plurality of second bit groups that are output by the plurality of first delay units through round robin, where at least one second bit group includes symbols that are output by the plurality of first delay units through round robin for one time, or at least one second bit group includes identification information and symbols that are output by the plurality of first delay units through round robin for one time, and the identification information indicates a start interleaving location at which the convolutional interleaving is performed on the symbols included in the plurality of first codewords; and use, as the interleaving result, the plurality of second bit groups that are output by the plurality of first delay units through round robin.

In a possible implementation, the start interleaving location at which the convolutional interleaving is performed on the symbols included in the plurality of first codewords is in any one of the plurality of first delay units.

In a possible implementation, the symbols included in the plurality of first codewords are input into the plurality of first delay units of the convolution interleaver in a manner of a first data stream, and a transmission rate of the first data stream is greater than or equal to 100 Gbps.

In a possible implementation, the first data stream is transmitted to the plurality of first delay units of the convolution interleaver through at least one lane of an AUI.

According to a fourth aspect, a data transmission apparatus is provided. The apparatus is used in a second module, and the apparatus includes:
an obtaining unit, configured to receive second data that includes identification information and that is transmitted by a first module, where the second data is obtained based on an interleaving result obtained by performing convolutional interleaving on symbols included in a plurality of first codewords, the first codeword is a codeword obtained by encoding first data by using a first FEC code, and if the second data includes a second codeword, the identification information includes codeword boundary information of the second codeword, where
the obtaining unit is further configured to obtain, based on the identification information, to-be-de-interleaved data in the second data and a start interleaving location at which the convolutional interleaving is performed on the symbols included in the plurality of first codewords; and
a de-interleaving unit, configured to perform convolutional de-interleaving on the to-be-de-interleaved data based on the start interleaving location, to obtain the plurality of first codewords.

In a possible implementation, the obtaining unit is configured to: obtain, based on the codeword boundary information of the second codeword, at least one second codeword included in the second data, obtain a start location of the at least one second codeword, use the start location as the start interleaving location at which the convolutional interleaving is performed on the symbols included in the plurality of first codewords, and decode the at least one second codeword to obtain the to-be-de-interleaved data.

In a possible implementation, if the second data does not include the second codeword, the identification information is frame synchronization information, and the obtaining unit is configured to: obtain, based on the frame synchronization information, at least one target data frame included in the second data, obtain a start location of frame data of the at least one target data frame, use the start location as the start interleaving location, and use, as the to-be-de-interleaved data, the frame data included in the at least one target data frame.

In a possible implementation, the to-be-de-interleaved data includes a plurality of third bit groups, one third bit group includes symbols that are of the first codewords and that are output by a plurality of first delay units of a convolution interleaver through round robin for one time, and the de-interleaving unit is configured to: obtain a start de-interleaving location that corresponds to the start interleaving location and that is in a plurality of second delay units of a convolution de-interleaver, input, at the start de-interleaving location, the plurality of third bit groups into the plurality of second delay units, perform, via the plurality of second delay units, convolutional de-interleaving on symbols that are included in the plurality of third bit groups and that are obtained through round robin, obtain the symbols that are included in the plurality of first codewords and that are output by the plurality of second delay units through round robin, and obtain the plurality of first codewords based on the symbols included in the plurality of first codewords.

In a possible implementation, if the second data does not include the second codeword, the identification information indicates the start interleaving location at which the convolutional interleaving is performed on the symbols included in the plurality of first codewords, and the obtaining unit is configured to: obtain the start interleaving location that is indicated by the identification information and at which the convolutional interleaving is performed on the symbols included in the plurality of first codewords, and use data at the start interleaving location and data after the start interleaving location that are in the second data as the to-be-de-interleaved data.

In a possible implementation, the to-be-de-interleaved data includes a plurality of fourth bit groups; at least one fourth bit group includes symbols that are of the first codewords and that are output by a plurality of first delay units of a convolution interleaver through round robin for one time, or at least one fourth bit group includes identification information and symbols that are output by a plurality of first delay units through round robin for one time; and the de-interleaving unit is configured to: obtain a start de-interleaving location that corresponds to the start interleaving location and that is in a plurality of second delay units of a convolution de-interleaver, input, at the start de-interleaving location, the plurality of fourth bit groups into the plurality of second delay units, perform, via the plurality of second delay units, convolutional de-interleaving on symbols that are included in the plurality of fourth bit groups and that are obtained through round robin or on identification information and symbols that are included in the plurality of fourth bit groups and that are obtained through round robin, obtain the symbols included in the plurality of first codewords and the identification information that are output by the plurality of second delay units through round robin, and obtain the plurality of first codewords based on the symbols included in the plurality of first codewords.

In a possible implementation, the start de-interleaving location is in any one of the plurality of second delay units.

In a possible implementation, the plurality of second delay units of the convolution de-interleaver output, in a manner of a second data stream, the symbols included in the plurality of first codewords, and a transmission rate of the second data stream is greater than or equal to 100 Gbps.

In a possible implementation, the plurality of second delay units of the convolution de-interleaver output the second data stream through at least one lane of an AUI.

According to a fifth aspect, a data transmission system is provided. The system includes a first module and a second module. The first module is configured to perform the data transmission method in any implementation of the first aspect. The second module is configured to perform the data transmission method in any implementation of the second aspect.

According to a sixth aspect, a computer system is provided. The computer system includes a processor, and the processor includes a first module or a second module. If the processor includes the first module, when the processor executes program instructions or code, the computer system implements the data transmission method in any implementation of the first aspect. If the processor includes the second module, when the processor executes program instructions or code, the computer system implements the data transmission method in any implementation of the second aspect. For example, the computer system further includes a memory, and the memory is configured to store the program instructions or the code.

According to a seventh aspect, a computer-readable storage medium is provided. The computer-readable storage medium stores at least one program instruction or code, the program instruction or the code is executed by a computer, and the computer includes a first module or a second module. If the computer includes the first module, when the program instruction or the code is executed by the computer, the computer is enabled to implement the data transmission method in any implementation of the first aspect. If the computer includes the second module, when the program instruction or the code is executed by the computer, the computer is enabled to implement the data transmission method in any implementation of the second aspect.

According to an eighth aspect, a communication apparatus is provided. The apparatus includes a transceiver, a memory, and a processor. The transceiver, the memory, and the processor communicate with each other through an internal connection path. The memory is configured to store instructions. The processor is configured to execute the instructions stored in the memory, to control the transceiver to receive and send a signal. The processor includes a first module or a second module. If the processor includes the first module, when the processor executes the instructions stored in the memory, the processor is enabled to perform the data transmission method in any implementation of the first aspect. If the processor includes the second module, when the processor executes the instructions stored in the memory, the processor is enabled to perform the data transmission method in any implementation of the second aspect.

For example, there are one or more processors, and there are one or more memories.

For example, the memory and the processor may be integrated together, or the memory and the processor are disposed separately.

In a specific implementation process, the memory may be a non-transitory (non-transitory) memory, for example, a read-only memory (read-only memory, ROM). The memory and the processor may be integrated on a same chip, or may be separately disposed on different chips. A type of the memory and a manner of disposing the memory and the processor are not limited in this application.

According to a ninth aspect, a computer program or a computer program product is provided. The computer program or the computer program product includes computer program instructions or code, the computer program instructions or the code is run by a computer, and the computer includes a first module or a second module. If the computer includes the first module, when the computer program instructions or the code is run by the computer, the computer is enabled to perform the data transmission method in any implementation of the first aspect. If the computer includes the second module, when the computer program instructions or the code is run by the computer, the computer is enabled to perform the data transmission method in any implementation of the second aspect.

According to a tenth aspect, a chip is provided. The chip includes a processor, the processor includes a first module or a second module, and the processor is configured to run program instructions or code. If the processor includes the first module, a device including the chip performs the data transmission method in any implementation of the first aspect. If the processor includes the second module, a device including the chip performs the data transmission method in any implementation of the second aspect.

For example, the chip further includes an input interface, an output interface, and a memory. The input interface, the output interface, the processor, and the memory are connected through an internal connection path. The memory is configured to store the program instructions or the code.

It should be understood that, for beneficial effects achieved by the technical solutions of the third aspect to the tenth aspect and corresponding possible implementations of the technical solutions of the third aspect to the tenth aspect of this application, refer to technical effects of the first aspect, the second aspect, and the corresponding possible implementations of the first aspect and the second aspect. Details are not described herein again.

### BRIEF DESCRIPTION OF DRAWINGS

FIG. 1 is a diagram of random errors and burst errors according to an embodiment of this application;
FIG. 2 is a diagram of a process of using an interleaver and a de-interleaver according to an embodiment of this application;
FIG. 3 is a diagram of an interleaving process according to an embodiment of this application;
FIG. 4 is a diagram of a start interleaving location according to an embodiment of this application;
FIG. 5 is a diagram of an implementation scenario according to an embodiment of this application;
FIG. 6 is a diagram of another implementation scenario according to an embodiment of this application;
FIG. 7 is a diagram of still another implementation scenario according to an embodiment of this application;
FIG. 8 is a flowchart of a data transmission method according to an embodiment of this application;
FIG. 9 is a diagram of a process of obtaining second data according to an embodiment of this application;
FIG. 10 is a diagram of another process of obtaining second data according to an embodiment of this application;
FIG. 11 is a diagram of still another process of obtaining second data according to an embodiment of this application;
FIG. 12 is a diagram of yet another process of obtaining second data according to an embodiment of this application;
FIG. 13 is a diagram of a structure of a data transmission apparatus according to an embodiment of this application;
FIG. 14 is a diagram of a structure of another data transmission apparatus according to an embodiment of this application;
FIG. 15 is a diagram of a structure of a computer system according to an embodiment of this application; and
FIG. 16 is a diagram of a structure of another computer system according to an embodiment of this application.

### DESCRIPTION OF EMBODIMENTS

Terms used in implementations of this application are merely used to explain embodiments of this application, but are not intended to limit this application. The following describes embodiments of this application with reference to the accompanying drawings.

In a data transmission process, a bit error remains an inevitable problem due to presence of environmental interference and a system error. The bit error is a bit that is in data received by a receiving end of the data and that is inconsistent with that in data sent by a transmitting end of the data. The bit error in the data may cause breakdown and a data loss of a data transmission system. In addition, the bit error may affect a communication delay and user experience in videos, games, calls, and the like. Therefore, a quantity of bit errors in the received data, namely, a bit error rate (BER) of the data, has been an indicator for measuring performance of a communication system.

A smaller BER of the data indicates higher reliability of data transmission. Therefore, reliability of the data transmission system can be ensured by limiting the BER of the received data. For example, the Institute of Electrical and Electronics Engineers (Institute of Electrical and Electronics Engineers, IEEE) 802.3 400 Gigabit Ethernet (Gigabit Ethernet, GE) standard requires that a BER of the data at the receiving end when the data enters a media access control (media access control, MAC) layer be lower than le-13, where 1e-13 has a same meaning as 1x10⁻¹³. A BER of data when the data enters the receiving end through link transmission is approximately 2e-4, where 2e-4 has a same meaning as 2x10⁻⁴. In this case, the data is encoded by using an FEC code at the transmitting end of the data, and the received data is decoded by using the same FEC code at the receiving end of the data, to correct the bit error in the received data. This becomes a manner of eliminating the bit error that occurs in the data transmission process. After error correction is performed on the bit error in the data based on the FEC code, a BER of the received data is low.

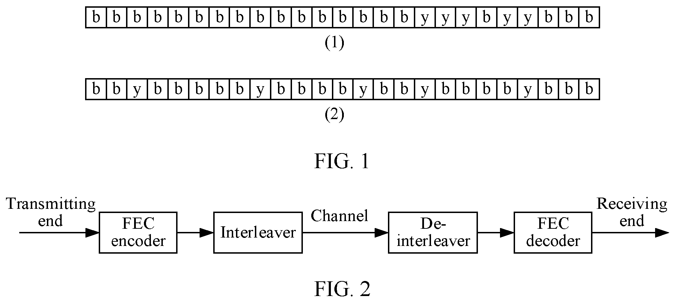

Based on distribution, bit errors include random errors and non-random errors, and the non-random errors may also be referred to as burst errors (burst error). FIG. 1 is a diagram of a scenario of random errors and burst errors according to an embodiment of this application. In FIG. 1, b represents correct data, and y represents a bit error (1) in FIG. 1 represents distribution of the random errors, (2) in FIG. 1 represents distribution of the burst errors, and BERs of data shown in (1) and (2) in FIG. 1 are the same.

Because the distribution of the bit errors in the data varies, when BERs before the error correction are the same, BERs after the error correction may be different. In most data transmission conditions, based on the same BERs before the error correction, the burst errors cause a higher BER that is after the error correction than the random errors. Therefore, the data is interleaved via an interleaver, so that the BER after the error correction can be further reduced for the burst errors.

FIG. 2 is a diagram of a process of using an interleaver and a de-interleaver according to an embodiment of this application. Data locations are adjusted at a transmitting end of data through interleaving, and the data locations are restored at a receiving end of the data through de-interleaving, so that burst errors that occur during transmission of the data through a transmission channel are dispersed. In this way, distribution of the burst errors after the de-interleaving is close to that of random errors, to reduce a BER after error correction. As shown in FIG. 2, the transmitting end of the data may perform FEC encoding on the data via an FEC encoder before the interleaving, and interleave FEC encoded data via the interleaver. Interleaved data is transmitted to the receiving end through the channel. The receiving end may de-interleave the received data via the de-interleaver, and perform FEC decoding on data via an FEC decoder after the de-interleaving. An FEC code used by the FEC encoder at the transmitting end is the same as that used by the FEC decoder at the receiving end. For example, the FEC code is a Reed-Solomon (Reed-Solomon, RS) code, a Bose-Chaudhuri-Hocquenghem (Bose-Chaudhuri-Hocquenghem, BCH) code, an extended BCH code, a Hamming code, an extended Hamming code, a staircase (staircase) code, a low-density parity-check (low-density parity-check, LDPC) code, a turbo (turbo) code, or a turbo product code (turbo product code, TPC). The FEC code mentioned in another part of this application may also be a Reed-Solomon (Reed-Solomon, RS) code, a Bose-Chaudhuri-Hocquenghem (Bose-Chaudhuri-Hocquenghem, BCH) code, an extended BCH code, a Hamming code, an extended Hamming code, a staircase (staircase) code, a low-density parity-check (low-density parity-check, LDPC) code, a turbo (turbo) code, or a turbo product code (turbo product code, TPC).

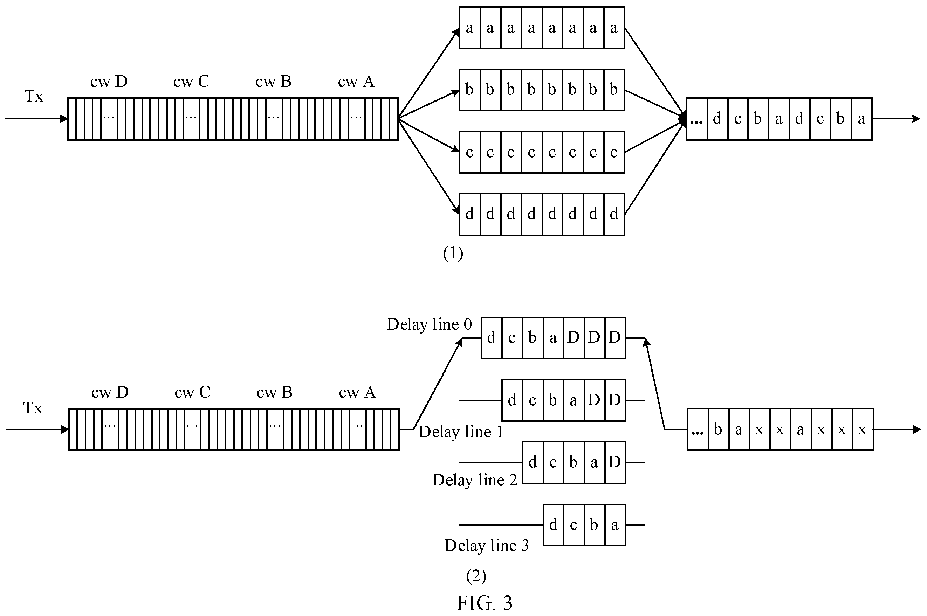

In some embodiments, the interleaver may include a block interleaver (block interleaver) and a convolution interleaver (convolution interleaver). FIG. 3 is a diagram of an interleaving process according to an embodiment of this application. (1) in FIG. 3 is a diagram of interleaving data by a block interleaver, and (2) in FIG. 3 is a diagram of interleaving data by a convolution interleaver. (1) in FIG. 3 is used as an example. On a transmitting side (transmitter, Tx) of the data, a codeword (codeword, cw) A to a codeword D that are encoded based on a first FEC code are arranged into four rows, and then a symbol of an FEC codeword is used as a granularity for outputting by column to form interleaved data. In (1) in FIG. 3, a represents a symbol included in the cw A, b represents a symbol included in the cw B, c represents a symbol included in the cw C, and d represents a symbol included in the cw D.

(2) in FIG. 3 is used as an example. The convolution interleaver includes a plurality of delay units. The delay unit may correspond to a delay line (delay line) shown in (2) in FIG. 3. A delay length corresponding to each delay line is determined based on a delay block length (delay block length) and a delay block number (delay block number) of each delay line. As shown in (2) in FIG. 3, a quantity of delay lines is 4, and the four delay lines may be a delay line 0, a delay line 1, a delay line 2, and a delay line 3 in a top-to-bottom sequence. A delay block may be implemented by a linear-feedback shift register (linear-feedback shift register, LFSR), and the delay block may store data. For example, if delay blocks in each delay line have a same size, each delay line has a different quantity of delay blocks; or if delay blocks in each delay line have different sizes, each delay line has a same quantity of delay blocks. An input side and an output side of the convolution interleaver each have a switchable connection switch, and two connection switches are configured to both connect to a delay line. As shown in (2) in FIG. 3, symbols of an FEC codeword may enter the convolution interleaver by column. Each time one symbol enters from the input side, the output side outputs one symbol, and then the connection switches on both sides switch to a next delay line. Round robin may be performed on a plurality of delay lines in a sequence of numbers 0, 1, 2, 3, 0, 1, 2, 3, 0, 1, .... In (2) in FIG. 3, the delay block is represented by D, and data that is stored in the delay block and that is before a cw A to a cw D is represented by x.

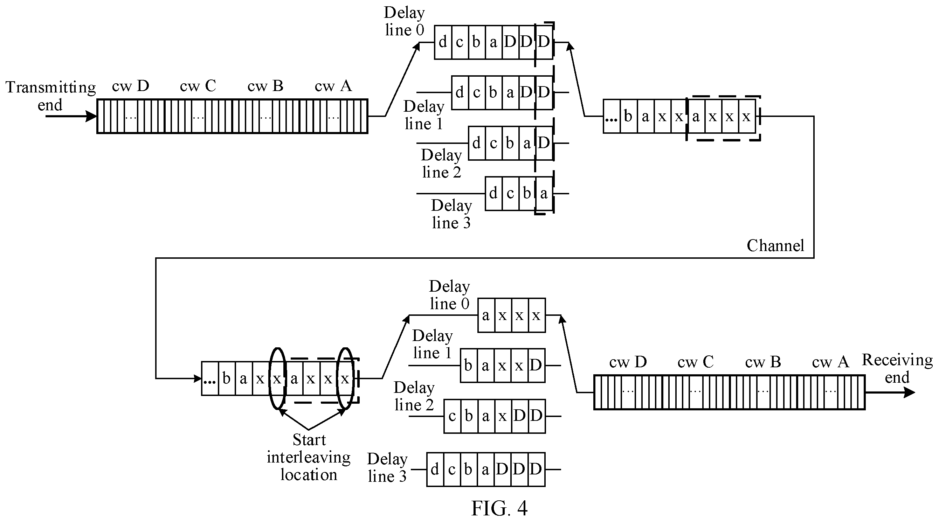

Because the convolution interleaver includes a plurality of delay units, and each delay unit has a different delay length, when performing de-interleaving, a receiving end of the data needs to determine a start interleaving location for interleaving the symbol, to obtain correct data. In embodiments of this application, the start interleaving location may also be referred to as a synchronization location. Because the plurality of delay units input and output symbols in a round robin manner, the start interleaving location periodically appears in a data stream obtained through convolutional interleaving. FIG. 4 is a diagram of a start interleaving location according to an embodiment of this application. A data stream shown in FIG. 4 may be the data stream obtained through the convolutional interleaving shown in (2) in FIG. 3. In the data stream, the start interleaving location is a circle location in FIG. 4. FIG. 4 further shows a process of performing convolutional de-interleaving on the data stream obtained through the interleaving. Refer to FIG. 4. A plurality of symbols received through a channel are input into a plurality of delay units of a convolution de-interleaver through round robin, and convolutional de-interleaving is performed on the plurality of symbols via the plurality of delay units of the convolution de-interleaver, to obtain a cw A to a cw D based on symbols output by the plurality of delay units of the convolution de-interleaver through round robin.

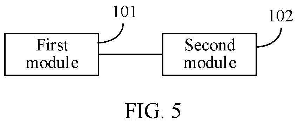

An embodiment of this application provides a data transmission method, to implement data transmission based on FEC in combination with convolutional interleaving. The method may be applied to an implementation scenario shown in FIG. 5. Refer to FIG. 5. The implementation scenario includes a first module 101 and a second module 102, and the first module 101 is communicatively connected to the second module 102. For example, the first module 101 is included in a first device, the second module 102 is included in a second device, and the first module 101 and the second module 102 may alternatively be included in a same device. Devices in which the first module 101 and the second module 102 are located may be network devices, or may be other devices based on an Ethernet interface.

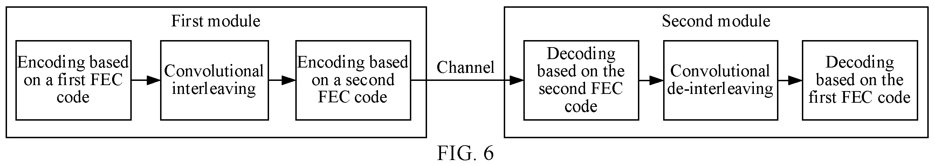

The implementation scenario shown in FIG. 5 may be combined with a cascaded encoding scenario. In other words, an implementation environment of the method may be shown in FIG. 6. Refer to FIG. 6. The first module 101 may perform encoding based on a first FEC code, convolutional interleaving, and encoding based on a second FEC code, and then transmit, to the second module 102 through a channel, data obtained through the encoding based on the second FEC code. The second module 102 may perform decoding based on the second FEC code, convolutional de-interleaving, and decoding based on the first FEC code. In a possible implementation, after obtaining the data through the encoding based on the second FEC code, the first module 101 may further interleave the data, and transmit, to the second module 102 through the channel, data that is obtained through the encoding based on the second FEC code and that is interleaved. Correspondingly, the second module 102 may further de-interleave the data that is obtained through the encoding based on the second FEC code and that is interleaved, to obtain the data obtained through the encoding based on the second FEC code, and then perform decoding based on the second FEC code and other subsequent operations. A manner of interleaving the data obtained through the encoding based on the second FEC code includes but is not limited to block interleaving and convolutional interleaving. If the interleaving manner is the block interleaving, a manner in which the second module 102 de-interleaves the data that is obtained through the encoding based on the second FEC code and that is interleaved is block de-interleaving. If the interleaving manner is the convolutional interleaving, a manner in which the second module 102 de-interleaves the data that is obtained through the encoding based on the second FEC code and that is interleaved is convolutional de-interleaving.

In addition, the foregoing uses an example in which the first module 101 in FIG. 6 uses two times of interleaving, the 1^{st} time of interleaving is the convolutional interleaving, and the 2^{nd} time of interleaving is the convolutional interleaving or the block interleaving for description. In a possible implementation, the method provided in embodiments of this application may further support a manner in which the first module 101 uses the block interleaving for the 1^{st} time of interleaving, and uses the convolutional interleaving for the 2^{nd} time of interleaving. Correspondingly, the second module 102 performs two times of de-interleaving. A manner of the 1^{st} time of de-interleaving is the block de-interleaving, and a manner of the 2^{nd} time of de-interleaving is the convolutional de-interleaving. Regardless of a sequence in which the convolutional interleaving or the convolutional de-interleaving is performed, reference can be made to the convolutional interleaving and convolutional de-interleaving manners provided in this embodiment of this application.

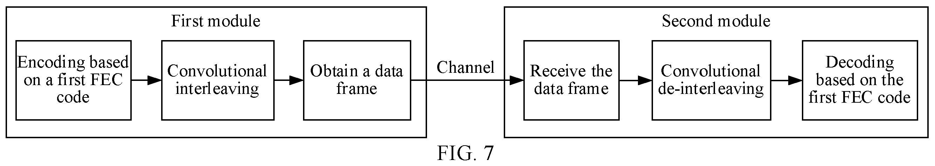

The implementation scenario shown in FIG. 5 may alternatively be combined with a non-cascaded encoding scenario. In other words, an implementation environment of the method may be shown in FIG. 7. Refer to FIG. 7. The first module 101 may perform encoding based on a first FEC code, perform convolutional interleaving, and obtain a data frame, and then transmit the obtained data frame to the second module 102 through a channel. The second module 102 may receive the data frame, perform convolutional de-interleaving, and perform decoding based on the first FEC code. The implementation scenarios shown in FIG. 5 to FIG. 7 may further include another module. This is not limited in embodiments of this application.

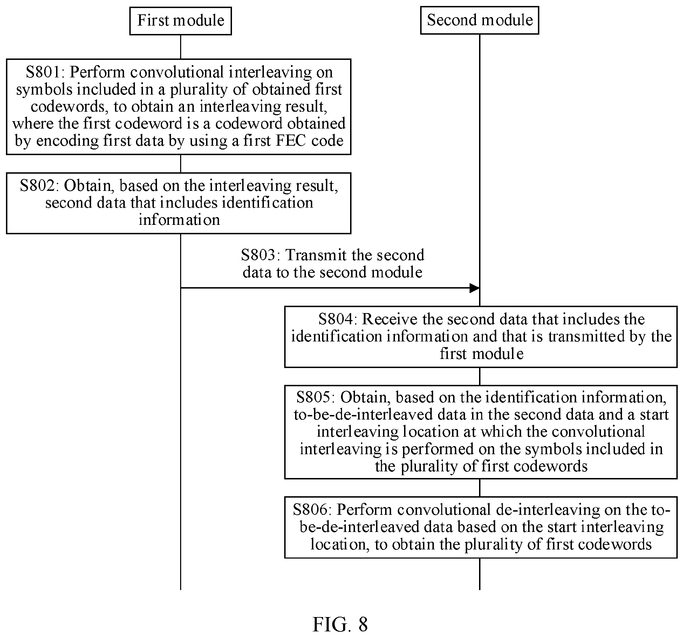

The data transmission method provided in this embodiment of this application may be shown in FIG. 8. The following describes the data transmission method provided in this embodiment of this application with reference to the implementation scenario shown in FIG. 5. As shown in FIG. 8, the method includes S801 to S803.

S801: A first module performs convolutional interleaving on symbols included in a plurality of obtained first codewords, to obtain an interleaving result, where the first codeword is a codeword obtained by encoding first data by using a first FEC code.

A manner in which the first module obtains the first codeword is not limited in embodiments of this application. For example, the first module may receive a plurality of first codewords transmitted by another module, or the first module encodes the first data based on the first FEC code, to obtain the plurality of first codewords. The first data may be data that is received by the first module and that is transmitted by another module, or data generated by the first module.

For example, symbols that are of a plurality of first codewords and that are used for the convolutional interleaving may be distributed. For example, the first module distributes symbols included in first codewords, to obtain a plurality of channels of data, where any channel of data includes symbols from a plurality of first codewords, and then symbols included in each channel of data are used as the symbols used for the convolutional interleaving. Certainly, the first module may alternatively not distribute symbols included in a plurality of first codewords, and directly use, as the symbols used for the convolutional interleaving, the symbols included in the plurality of first codewords.

In embodiments of this application, a quantity of bits included in the symbols used for the convolutional interleaving may be related to or unrelated to the first FEC code. For example, the quantity of bits included in the symbols used for the convolutional interleaving is equal to a quantity of bits included in symbols of a codeword of the first FEC code, or the quantity of bits included in the symbols used for the convolutional interleaving may be determined based on experience or an actual requirement. The quantity of bits included in the symbols used for the convolutional interleaving is not limited in embodiments of this application.

In a possible implementation, the performing convolutional interleaving on symbols included in a plurality of obtained first codewords, to obtain an interleaving result includes the following manner 1 and manner 2.

Manner 1: The symbols included in the plurality of first codewords are input into a plurality of first delay units of a convolution interleaver. The convolutional interleaving is performed via the plurality of first delay units on the symbols that are included in the plurality of first codewords and that are obtained through round robin, to obtain a plurality of first bit groups that are output by the plurality of first delay units through round robin, where one first bit group includes symbols that are output by the plurality of first delay units through round robin for one time. The plurality of first bit groups that are output by the plurality of first delay units through round robin are used as the interleaving result.

If the convolutional interleaving is performed via the plurality of first delay units of the convolution interleaver, a start interleaving location at which the convolutional interleaving is performed on the symbols included in the plurality of first codewords may be a round robin start location at which the symbols of the first codewords are input through round robin. For example, the convolution interleaver includes four first delay units, and the four first delay units are numbered as a first delay unit 0 to a first delay unit 3. If inputting of the symbols of the first codewords starts from the first delay unit 0 through round robin, the start interleaving location is in the first delay unit 0. If inputting of the symbols of the first codewords starts from the first delay unit 1 through round robin, the start interleaving location is in the first delay unit 1. If inputting of the symbols of the first codewords starts from the first delay unit 2 or the first delay unit 3 through round robin, a principle of the start interleaving location is the same as the foregoing descriptions. Details are not described herein again. With reference to the foregoing content, it can be learned that in this embodiment of this application, the start interleaving location at which the convolutional interleaving is performed on the symbols included in the plurality of first codewords may be in any one of the plurality of first delay units.

For example, if symbols that are output by the plurality of first delay units through round robin for one time are used as one first bit group, symbols that are output by the plurality of first delay units through round robin for n times are used as n first bit groups, and the n first bit groups are used as the interleaving result, where n is a positive integer. If the delay unit is a delay line, a plurality of delay lines may output symbols by column. Therefore, if the start interleaving location is in a 1^{st} delay line of the plurality of delay lines, symbols that are output by the plurality of delay lines through round robin for one time are located in a same column. If the start interleaving location is in a delay line other than the 1^{st} delay line of the plurality of delay lines, symbols that are output by the plurality of delay lines through round robin for one time are located in different columns.

In the manner 1, in a process of obtaining the interleaving result through the convolutional interleaving, the convolutional interleaving is performed only on the symbols included in the plurality of first codewords, and no additional data is introduced. Therefore, an amount of data for performing convolutional interleaving is small, and efficiency of the convolutional interleaving is high. In embodiments of this application, in a non-cascaded encoding scenario, the first module may further obtain identification information, where the identification information indicates the start interleaving location at which the convolutional interleaving is performed on the symbols included in the plurality of first codewords; and perform convolutional interleaving on both the identification information and the symbols included in the plurality of first codewords. In this case, an obtained interleaving result includes the identification information indicating the start interleaving location. For a process of performing convolutional interleaving on both the identification information and the symbols included in the plurality of first codewords, refer to the following manner 2.

Manner 2: At least one piece of identification information and the symbols included in the plurality of first codewords are input into a plurality of first delay units of a convolution interleaver. Convolutional interleaving is performed via the plurality of first delay units on the at least one piece of identification information that is obtained through round robin and the symbols that are included in the plurality of first codewords and that are obtained through round robin, to obtain a plurality of second bit groups that are output by the plurality of first delay units through round robin, where at least one second bit group includes symbols that are output by the plurality of first delay units through round robin for one time, or at least one second bit group includes identification information and symbols that are output by the plurality of first delay units through round robin for one time. The plurality of second bit groups that are output by the plurality of first delay units through round robin are used as the interleaving result.

A quantity of bits included in the identification information may be equal to a quantity of bits included in the symbol. If the interleaving result is obtained in the manner 2, a specific form of the identification information may be set based on experience or an actual requirement, provided that the identification information can indicate the start interleaving location. This is not limited in embodiments of this application.

In the manner 2, the start interleaving location may alternatively be in any one of the plurality of first delay units. This is not limited in this embodiment of this application. Because the convolutional interleaving is performed on both the identification information and the symbols of the first codewords in the manner 2, one second bit group output by the plurality of first delay units through round robin for one time may include only the symbols, or may include both the symbols and the identification information. For example, the plurality of first delay units output one second bit group through round robin for one time. If the plurality of first delay units perform outputting for t times through round robin, the plurality of first delay units output t second bit groups, and the t second bit groups are used as the interleaving result, where t is a positive integer.

For example, the symbols included in the plurality of first codewords are input into the plurality of first delay units of the convolution interleaver in a manner of a first data stream, and a transmission rate of the first data stream is greater than or equal to 100 Gbps. Certainly, the transmission rate of the first data stream may alternatively be a higher rate. For example, the transmission rate of the first data stream is greater than or equal to 200 Gbps. In a possible implementation, the first data stream may be transmitted to the plurality of first delay units of the convolution interleaver through at least one lane of an AUI. In this embodiment of this application, the convolutional interleaving may be performed on both the at least one piece of identification information and the symbols included in the plurality of first codewords. In this case, the at least one piece of identification information and the symbols included in the plurality of first codewords may alternatively be input into the plurality of first delay units of the convolution interleaver in a manner of a data stream, that is, the first data stream may include the at least one piece of identification information and the symbols included in the plurality of first codewords. In this embodiment of this application, the symbols or the identification information in the first data stream is input into the plurality of first delay units in a round robin manner.

S802: The first module obtains, based on the interleaving result, second data that includes the identification information.

With reference to the content of S801, the identification information may indicate the start interleaving location at which the convolutional interleaving is performed on the symbols included in the plurality of first codewords. Because the interleaving result obtained in the manner 1 does not include the identification information, the first module may introduce the identification information when obtaining the second data based on the interleaving result. For example, if the second data includes a second codeword, the identification information includes codeword boundary information of the second codeword. In other words, the codeword boundary information of the second codeword may indicate the start interleaving location at which the convolutional interleaving is performed on the symbols included in the plurality of first codewords. Because the interleaving result obtained in the manner 2 includes the identification information, the first module may directly use the obtained interleaving result as the second data, to improve efficiency of obtaining the second data. If the interleaving result is directly used as the second data, the second data does not include the second codeword. In this embodiment of this application, the second codeword may be a codeword obtained by performing FEC encoding on the interleaving result based on a second FEC code. For content of obtaining the second codeword, refer to content in the following manner A1. Details are not described herein. If the second data does not include the second codeword, it means that the method is applicable to the non-cascaded encoding scenario.

For example, if the interleaving result is obtained in the manner 1, the interleaving result includes the n first bit groups that are output by the plurality of first delay units through round robin for n times. If the method is applied to a cascaded encoding scenario, the second data may be obtained in the following mannerA1.

Manner A1: The n first bit groups that are output by the plurality of first delay units through round robin for n times are encoded based on the second FEC code, to obtain m second codewords, where a quantity of bits corresponding to the n first bit groups is equal to a quantity of bits included in information bits of the m codewords of the second FEC code, both m and n are positive integers, and m is less than or equal to n. The second data is obtained based on the m second codewords.

If the second data includes the second codeword, the identification information includes the codeword boundary information of the second codeword. The second codeword includes information bits and parity bits, and the codeword boundary information of the second codeword may include a demarcation location that is between a parity bit of a 1^{st} second codeword in two adjacent second codewords and an information bit of a following second codeword.

The second FEC code is not limited in embodiments of this application, and the second FEC code may be determined based on experience or an actual requirement. For example, if an FEC code is used as the second FEC code, a quantity of bits corresponding to one first bit group is equal to a quantity of bits included in information bits of one codeword of the second FEC code, that is, n second codewords are obtained by encoding the n first bit groups, where m is equal to n. For another example, if an FEC code is used as the second FEC codeword, a quantity of bits corresponding to a plurality of first bit groups is equal to a quantity of bits included in information bits of one codeword of the second FEC code, that is, the m second codewords are obtained by encoding the n first bit groups, where m is less than n.

The quantity of bits included in the n first bit groups depends on a quantity of delay units included in the convolution interleaver and a quantity of bits included in the symbol, and the quantity of bits included in the symbol may be determined based on a delay length corresponding to a delay block of the delay unit. In other words, the quantity of bits included in the n first bit groups may be determined based on a structure of the convolution interleaver. If the quantity of bits corresponding to the n first bit groups is equal to the quantity of bits included in the information bits of the m codewords of the second FEC code, because a value relationship between m and n is flexible, it means that an adaptation relationship between the convolution interleaver and the second FEC code is flexible. If both m and n are greater than 2, and m and n are not equal, at least two pieces of codeword boundary information of a plurality of second codewords are different. In the method provided in this embodiment of this application, when the second data that includes the identification information is obtained based on the interleaving result, additional data may be inserted into the interleaving result to serve as identification information, and the identification information indicates the start interleaving location.

The diagram in FIG. 4 is still used as an example. If n=3 and m=2, that is, two second codewords are obtained by encoding three first bit groups, there are two types of codeword boundary information of the second codeword. In this case, additional data may be inserted into the obtained interleaving result to serve as identification information to indicate the start interleaving location, so that the start interleaving location can be determined based on the inserted identification information during de-interleaving, to avoid failure to correctly perform de-interleaving due to different codeword boundary information, so as to ensure accuracy of the de-interleaving.

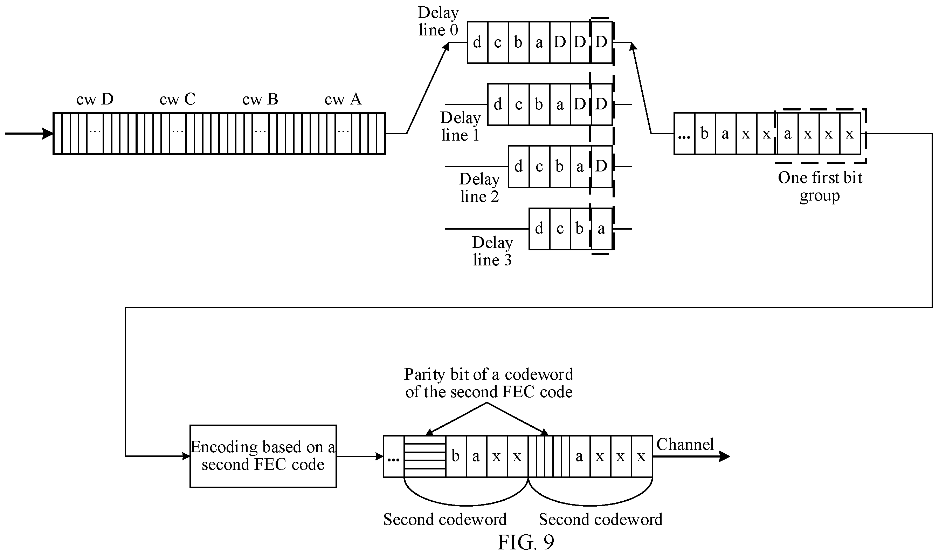

FIG. 9 is a diagram of a process of obtaining second data according to an embodiment of this application. In the process of obtaining the second data shown in FIG. 9, m is equal to n, that is, n bit groups are encoded based on the second FEC code to obtain n second codewords, where a quantity of bits corresponding to one first bit group is equal to a quantity of bits included in information bits of one codeword of the second FEC code. A principle of a process of performing convolutional interleaving on a cw A to a cw D shown in FIG. 9 is the same as that of the convolutional interleaving process shown in (2) in FIG. 3. Details are not described herein again.

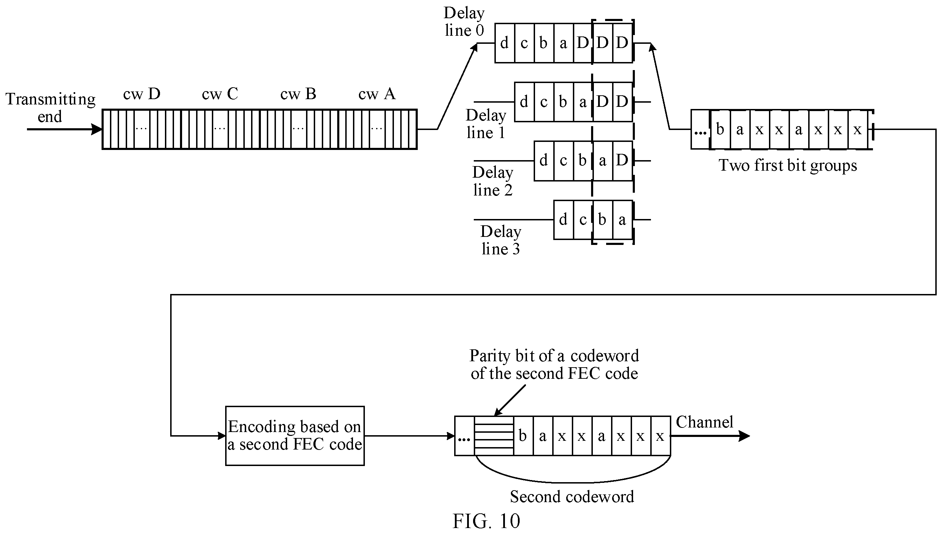

FIG. 10 is a diagram of another process of obtaining second data according to an embodiment of this application. In the process of obtaining the second data shown in FIG. 10, m is less than n, and a quantity of bits corresponding to two first bit groups is equal to a quantity of bits included in information bits of one codeword of the second FEC code. A principle of a process of performing convolutional interleaving on a cw A to a cw D shown in FIG. 10 is the same as that of the convolutional interleaving process shown in (2) in FIG. 3. Details are not described herein again.

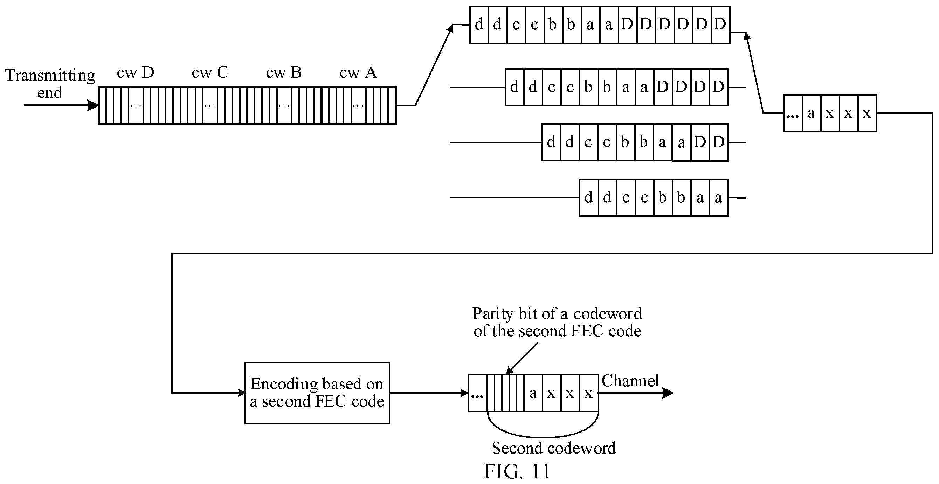

FIG. 9 and FIG. 10 are described by using an example in which symbols included in the cw A to the cw D consecutively appear in one delay unit. The method is further applicable to a scenario in which a plurality of symbols from one codeword consecutively appear in one delay unit. FIG. 11 is a diagram of still another process of obtaining second data according to an embodiment of this application. Refer to FIG. 11. The first codeword includes 320 bits, that is, a cw A to a cw D each include 320 bits, and the information bits of the codeword of the second FEC code include 160 bits. In FIG. 11, convolutional interleaving is performed on symbols included in the cw A to the cw D, and a quantity of delay lines of the convolution interleaver is equal to a quantity of first codewords, that is, the convolution interleaver includes four delay lines. In FIG. 11, a represents a symbol included in the cw A, b represents a symbol included in the cw B, c represents a symbol included in the cw C, and d represents a symbol included in the cw D. If symbols output by the convolution interleaver by column are used to obtain one second codeword obtained through encoding based on the second FEC code, each symbol included in the cw A to the cw D includes 40 bits, and a quantity of bits corresponding to a delay block included in each delay line is also 40 bits. Because one first codeword includes 320 bits, a difference between quantities of delay blocks included in each delay line is equal to (320/40)/4=2. Therefore, as shown in FIG. 11, D represents the delay block, a delay line 0 may include six delay blocks, a delay line 1 may include four delay blocks, a delay line 2 may include two delay blocks, and a delay line 3 may include zero delay blocks.

Still refer to FIG. 11. After convolutional interleaving is performed, via the delay lines, on symbols included in a plurality of first codewords, four adjacent output symbols are respectively from different first codewords. Therefore, if burst errors whose length is 160 bits occur in the second data, the bits included in the burst errors are dispersed onto four symbols, and the four symbols are from different first codewords, so that the burst errors are dispersed. In addition, as shown in FIG. 11, four symbols output in one column are used to obtain one codeword obtained through encoding based on the second FEC codeword. In other words, in FIG. 11, four symbols output by the four delay lines through round robin for one time are encoded based on the second FEC code, to obtain one second codeword.

The n first bit groups are encoded based on the second FEC code, to obtain the m second codewords, so that a receiving end can obtain the start interleaving location by obtaining the codeword boundary information of the second codeword, and then perform convolutional de-interleaving based on the start interleaving location, without inserting the identification information indicating the start interleaving location. In a manner of inserting the additional identification information, a link transmission rate increases, transmission bandwidth needed for data transmission increases, and higher data transmission costs are caused. In addition, because the manner of inserting the additional identification information causes the increase in the link transmission rate, in a data transmission scenario in which bandwidth or a frequency of a phase-locked loop is limited, applicability of the manner of inserting the additional identification information is poor. By contrast, in the manner A1, because no additional identification information needs to be inserted, and the codeword boundary information of the second codeword may be directly used as the identification information, data transmission costs of the method are low, and applicability to the data transmission scenario in which the bandwidth or the frequency of the phase-locked loop is limited is high.

If the method provided in this embodiment of this application is applied to the non-cascaded encoding scenario, the second data may be obtained in the following manner A2.

Manner A2: k target data frames are obtained based on a format of a reference data frame and the n first bit groups that are output by the plurality of first delay units through round robin for n times, where the target data frame includes frame synchronization information, the frame synchronization information is used as the identification information, a quantity of bits corresponding to the n first bit groups is less than or equal to a quantity of bits included in the k target data frames, both k and n are positive integers, and k is less than or equal to n. The second data is obtained based on the k target data frames.

In other words, in the non-cascaded encoding scenario, the second data may be obtained by obtaining the k target data frames based on the n first bit groups. In this case, the second data does not include the second codeword. For example, the frame synchronization information includes but is not limited to a frame alignment word (frame alignment word) in coherent transmission or other data used for frame synchronization. The format of the reference data frame may be determined based on a frame format that needs to be used for data transmission. This is not limited in embodiments of this application. For example, the k target data frames are used as the second data.

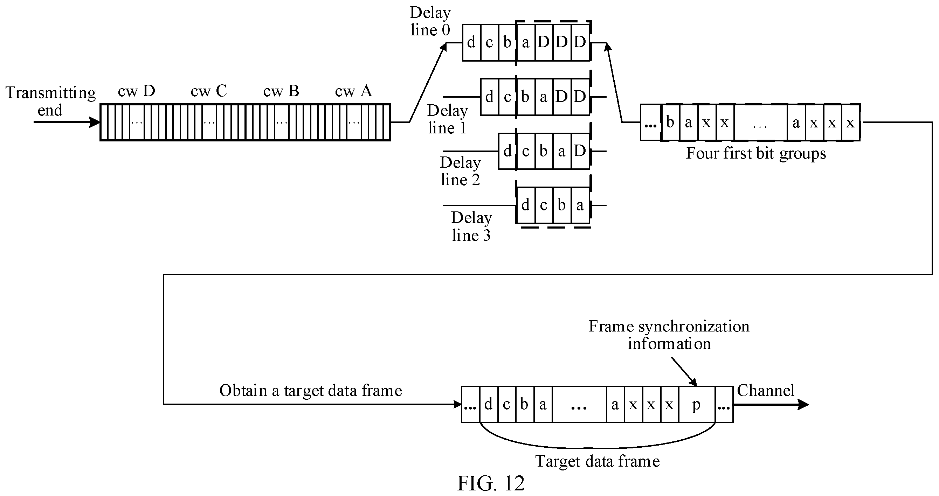

FIG. 12 is a diagram of yet another process of obtaining second data according to an embodiment of this application. In the process of obtaining the second data shown in FIG. 12, k is less than n, and four first bit groups are used to obtain one target data frame. A principle of a process of performing convolutional interleaving on a cw A to a cw D shown in FIG. 12 is the same as that of the convolutional interleaving process shown in (2) in FIG. 3. Details are not described herein again.

S803: The first module transmits the second data to a second module.

A manner in which the first module transmits the second data to the second data is not limited in this embodiment of this application. For example, the first module transmits the second data to the second module through a channel.

In the method provided in this embodiment of this application, the convolutional interleaving is performed on the symbols included in the plurality of first codewords, so that when burst errors occur in the second data subsequently, the burst errors are dispersed onto a plurality of symbols, to reduce a BER of the second data after error correction. In addition, if the second data includes the second codeword, the identification information is the codeword boundary information of the second codeword, and no additional identification information indicating the start interleaving location needs to be inserted, so that the data transmission costs are low, the applicability to the data transmission scenario in which the bandwidth or the frequency of the phase-locked loop is limited is high, and implementation complexity of a data transmission system used to perform the method is low.

The foregoing uses a first module side as an example to describe the data transmission method provided in this embodiment of this application. The following uses a second module side as an example to describe the data transmission method. As shown in FIG. 8, the data transmission method includes S804 to S806.

S804: The second module receives the second data that includes the identification information and that is transmitted by the first module.

A manner in which the second module receives the second data is not limited in this embodiment of this application, provided that the manner is adapted to the manner in which the first module transmits the second data to the second module. With reference to the content of S802, it can be learned that the second data is obtained based on the interleaving result obtained by performing convolutional interleaving on the symbols included in the plurality of first codewords, and the first codeword is the codeword obtained by encoding the first data by using the first FEC code. If the second data includes the second codeword, the identification information includes the codeword boundary information of the second codeword.

S805: The second module obtains, based on the identification information, to-be-de-interleaved data in the second data and the start interleaving location at which the convolutional interleaving is performed on the symbols included in the plurality of first codewords.

Based on different cases of the second data, the second module may perform, in different manners, an operation of obtaining, based on the identification information, the to-be-de-interleaved data in the second data and the start interleaving location at which the convolutional interleaving is performed on the symbols included in the plurality of first codewords.

Case B1: The second data includes the second codeword.

If the second data includes the second codeword, the second module obtains, based on the codeword boundary information of the second codeword, at least one second codeword included in the second data, obtains a start location of the at least one second codeword, uses the start location as the start interleaving location at which the convolutional interleaving is performed on the symbols included in the plurality of first codewords, and decodes the at least one second codeword to obtain the to-be-de-interleaved data.

For example, the codeword boundary information of the second codeword may be obtained in a codeword self-synchronization manner, so that the second module can obtain, based on the boundary information of the second codeword, the at least one second codeword included in the second data. For example, a process in which the second module obtains the codeword boundary information of the second codeword in the codeword self-synchronization manner includes: obtaining a local codeword of the second FEC code, and identifying the codeword boundary information of the second codeword based on the local codeword of the second FEC code. If the second data includes an alignment marker (alignment marker, AM), a location of the AM is associated with a location of the second codeword, so that the second module can obtain the codeword boundary information of the second codeword by determining the location of the AM in the second data.

The second codeword is obtained by encoding the n first bit groups based on the second FEC code, and the n first bit groups are obtained from the start interleaving location at which the convolutional interleaving is performed on the symbols included in the plurality of first codewords. Therefore, the start location of the second codeword may be used as the start interleaving location at which the convolutional interleaving is performed on the symbols included in the plurality of first codewords. A manner in which the second module decodes the second codeword only needs to correspond to a manner in which the second codeword is obtained through the encoding, in other words, the second module may decode the at least one second codeword based on the second FEC code, to obtain the to-be-de-interleaved data.

Case B2: The second data does not include the second codeword.

If the second data does not include the second codeword, and the second data includes at least one target data frame, the identification information is the frame synchronization information, and the second module may perform, in the following manner C1, the operation of obtaining, based on the identification information, the to-be-de-interleaved data in the second data and the start interleaving location at which the convolutional interleaving is performed on the symbols included in the plurality of first codewords.

Manner C1: The at least one target data frame included in the second data is obtained based on the frame synchronization information. A start location of frame data of the at least one target data frame is obtained. The start location is used as the start interleaving location at which the convolutional interleaving is performed on the symbols included in the plurality of first codewords. The frame data included in the at least one target data frame is used as the to-be-de-interleaved data.

For example, the second module divides the second data based on the frame synchronization information, to obtain the at least one target data frame included in the second data, where a quantity of target data frames may be k. In addition, after the at least one target data frame is obtained, a start location of frame data of each target data frame may be obtained. The k target data frames are obtained based on the n first bit groups, and the n first bit groups are obtained from the start interleaving location at which the convolutional interleaving is performed on the symbols included in the plurality of first codewords. Therefore, the start location of the frame data of the target data frame may be used as the start interleaving location at which the convolutional interleaving is performed on the symbols included in the plurality of first codewords.

If the second data neither includes the second codeword nor includes the target data frame, the identification information indicates the start interleaving location at which the convolutional interleaving is performed on the symbols included in the plurality of first codewords. The second module may perform, in the following manner C2, the operation of obtaining, based on the identification information, the to-be-de-interleaved data in the second data and the start interleaving location at which the convolutional interleaving is performed on the symbols included in the plurality of first codewords.

Manner C2: The start interleaving location that is indicated by the identification information and at which the convolutional interleaving is performed on the symbols included in the plurality of first codewords is obtained. Data at the start interleaving location and data after the start interleaving location that are in the second data are used as the to-be-de-interleaved data.

In other words, the identification information may directly indicate the start interleaving location at which the convolutional interleaving is performed on the symbols included in the plurality of first codewords, so that the second module uses the data at the start interleaving location and the data after the start interleaving location that are in the second data as the to-be-de-interleaved data.

S806: The second module performs convolutional de-interleaving on the to-be-de-interleaved data based on the start interleaving location, to obtain the plurality of first codewords.

For example, if the to-be-de-interleaved data is obtained in the manner in the case B1 or the manner C1 in the case B2, the to-be-de-interleaved data includes a plurality of third bit groups, and one third bit group includes symbols that are of the first codewords and that are output by the plurality of first delay units of the convolution interleaver through round robin for one time. Because a bit error may occur in a data transmission process, the bit error may exist in the third bit group.

If the to-be-de-interleaved data includes the plurality of third bit groups, the performing convolutional de-interleaving on the to-be-de-interleaved data based on the start interleaving location, to obtain the plurality of first codewords may include: obtaining a start de-interleaving location that corresponds to the start interleaving location and that is in a plurality of second delay units of a convolution de-interleaver, inputting, at the start de-interleaving location, the plurality of third bit groups into the plurality of second delay units, performing, via the plurality of second delay units, convolutional de-interleaving on symbols that are included in the plurality of third bit groups and that are obtained through round robin, obtaining the symbols that are included in the plurality of first codewords and that are output by the plurality of second delay units through round robin, and obtaining the plurality of first codewords based on the symbols included in the plurality of first codewords.

The start interleaving location may be the same as the start de-interleaving location. After obtaining the start interleaving location, the second module may use the start interleaving location as the start de-interleaving location. Similar to a case in which the start de-interleaving location may be in any one of the plurality of first delay units, the start de-interleaving location may be in any one of the plurality of second delay units. After the symbols included in the plurality of first codewords are obtained, the first codewords may be obtained based on the symbols included in the first codewords.

For example, if the to-be-de-interleaved data is obtained in the manner C2 in the case B2, the to-be-de-interleaved data includes a plurality of fourth bit groups, and at least one fourth bit group includes symbols that are of the first codewords and that are output by the plurality of first delay units of the convolution interleaver through round robin for one time, or at least one fourth bit group includes identification information and symbols that are output by the plurality of first delay units through round robin for one time. Because a bit error may occur in a data transmission process, the bit error may exist in the fourth bit group.

If the to-be-de-interleaved data includes the plurality of fourth bit groups, the performing convolutional de-interleaving on the to-be-de-interleaved data based on the start interleaving location, to obtain the plurality of first codewords may include: obtaining a start de-interleaving location that corresponds to the start interleaving location and that is in a plurality of second delay units of a convolution de-interleaver, inputting, at the start de-interleaving location, the plurality of fourth bit groups into the plurality of second delay units, performing, via the plurality of second delay units, convolutional de-interleaving on symbols that are included in the plurality of fourth bit groups and that are obtained through round robin or on identification information and symbols that are included in the plurality of fourth bit groups and that are obtained through round robin, obtaining the symbols included in the plurality of first codewords and the identification information that are output by the plurality of second delay units through round robin, and obtaining the plurality of first codewords based on the symbols included in the plurality of first codewords.

In this case, a principle of content in which the second module obtains the start de-interleaving location and a manner of performing convolutional de-interleaving and obtaining the plurality of first codewords is the same as that of related content in the foregoing case in which the to-be-de-interleaved data includes the plurality of third bit groups. Details are not described herein again.

For example, the plurality of second delay units of the convolution de-interleaver output, in a manner of a second data stream, the symbols included in the plurality of first codewords, and a transmission rate of the second data stream is greater than or equal to 100 Gbps. Certainly, the transmission rate of the second data stream may alternatively be a higher rate. For example, the transmission rate of the second data stream is greater than or equal to 200 Gbps. If the second data is obtained through convolutional interleaving performed on both the identification information and the symbols of the plurality of first codewords, the second data stream may further include the identification information. In this case, the plurality of second delay units of the convolution de-interleaver output, in the manner of the second data stream, the identification information and the symbols included in the plurality of first codewords. For example, the plurality of second delay units of the convolution de-interleaver output the second data stream through at least one lane of the AUI. The plurality of second delay units may input the second data stream into the at least one lane of the AUI in a round robin manner, to output the second data stream through the at least one lane of the AUI.

In the method provided in this embodiment of this application, because the second data is obtained by performing convolutional interleaving on the symbols included in the plurality of first codewords, when the burst errors occur in the second data, the burst errors are dispersed onto the plurality of symbols, to reduce the BER of the second data after the error correction. In addition, if the second data includes the second codeword, the identification information is the codeword boundary information of the second codeword, and no additional identification information indicating the start interleaving location needs to be inserted into the second data, so that the data transmission costs are low, the applicability to the data transmission scenario in which the bandwidth or the frequency of the phase-locked loop is limited is high, and the implementation complexity of the data transmission system used to perform the method is low.

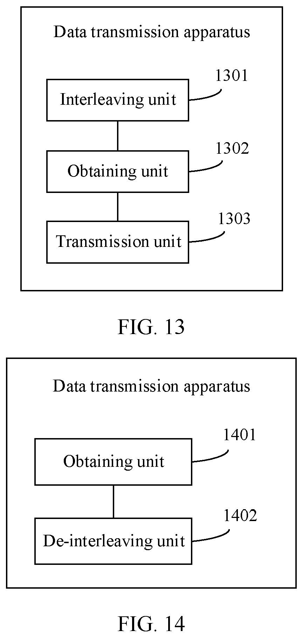

An embodiment of this application further provides a data transmission apparatus. FIG. 13 is a diagram of a structure of a data transmission apparatus according to an embodiment of this application. Based on a plurality of units shown in FIG. 13, the data transmission apparatus shown in FIG. 13 can perform all or some operations performed by a first module. It should be understood that the apparatus may include more additional units than the shown units or omit some of the shown units. This is not limited in this embodiment of this application. As shown in FIG. 13, the apparatus includes:
an interleaving unit 1301, configured to perform convolutional interleaving on symbols included in a plurality of obtained first codewords, to obtain an interleaving result, where the first codeword is a codeword obtained by encoding first data by using a first FEC code;
an obtaining unit 1302, configured to obtain, based on the interleaving result, second data that includes identification information, where if the second data includes a second codeword, the identification information includes codeword boundary information of the second codeword, and
a transmission unit 1303, configured to transmit the second data to a second module.

In a possible implementation, the interleaving unit 1301 is configured to: input the symbols included in the plurality of first codewords into a plurality of first delay units of a convolution interleaver; perform, via the plurality of first delay units, convolutional interleaving on the symbols that are included in the plurality of first codewords and that are obtained through round robin, to obtain a plurality of first bit groups that are output by the plurality of first delay units through round robin, where one first bit group includes symbols that are output by the plurality of first delay units through round robin for one time; and use, as the interleaving result, the plurality of first bit groups that are output by the plurality of first delay units through round robin.

In a possible implementation, the interleaving result includes n first bit groups that are output by the plurality of first delay units through round robin for n times, and the obtaining unit 1302 is configured to: encode, based on a second FEC code, the n first bit groups that are output by the plurality of first delay units through round robin for n times, to obtain m second codewords, where a quantity of bits corresponding to the n first bit groups is equal to a quantity of bits included in information bits of the m codewords of the second FEC code, both m and n are positive integers, and m is less than or equal to n; and obtain the second data based on the m second codewords.

In a possible implementation, the second data does not include the second codeword, the interleaving result includes n first bit groups that are output by the plurality of first delay units through round robin for n times, and the obtaining unit 1302 is configured to: obtain k target data frames based on a format of a reference data frame and the n first bit groups that are output by the plurality of first delay units through round robin for n times, where the target data frame includes frame synchronization information, the frame synchronization information is used as the identification information, a quantity of bits corresponding to the n first bit groups is less than or equal to a quantity of bits included in the k target data frames, both k and n are positive integers, and k is less than or equal to n; and obtain the second data based on the k target data frames.

In a possible implementation, the second data does not include the second codeword, and the interleaving unit 1301 is configured to: input at least one piece of identification information and the symbols included in the plurality of first codewords into a plurality of first delay units of a convolution interleaver; perform, via the plurality of first delay units, convolutional interleaving on the at least one piece of identification information that is obtained through round robin and the symbols that are included in the plurality of first codewords and that are obtained through round robin, to obtain a plurality of second bit groups that are output by the plurality of first delay units through round robin, where at least one second bit group includes symbols that are output by the plurality of first delay units through round robin for one time, or at least one second bit group includes identification information and symbols that are output by the plurality of first delay units through round robin for one time, and the identification information indicates a start interleaving location at which the convolutional interleaving is performed on the symbols included in the plurality of first codewords; and use, as the interleaving result, the plurality of second bit groups that are output by the plurality of first delay units through round robin.

In a possible implementation, the start interleaving location at which the convolutional interleaving is performed on the symbols included in the plurality of first codewords is in any one of the plurality of first delay units.

In a possible implementation, the symbols included in the plurality of first codewords are input into the plurality of first delay units of the convolution interleaver in a manner of a first data stream, and a transmission rate of the first data stream is greater than or equal to 100 Gbps.

In a possible implementation, the first data stream is transmitted to the plurality of first delay units of the convolution interleaver through at least one lane of an AUI.

In the apparatus provided in this embodiment of this application, the convolutional interleaving is performed on the symbols included in the plurality of first codewords, so that when burst errors occur in the second data subsequently, the burst errors are dispersed onto a plurality of symbols, to reduce a BER of the second data after error correction. In addition, if the second data includes the second codeword, the identification information is the codeword boundary information of the second codeword, and no additional identification information indicating the start interleaving location needs to be inserted, so that data transmission costs are low, applicability to a data transmission scenario in which bandwidth or a frequency of a phase-locked loop is limited is high, and implementation complexity of a data transmission system including the apparatus is low.

FIG. 14 is a diagram of a structure of another data transmission apparatus according to an embodiment of this application. Based on a plurality of units shown in FIG. 14, the data transmission apparatus shown in FIG. 14 can perform all or some operations performed by a second module. It should be understood that the apparatus may include more additional units than the shown units or omit some of the shown units. This is not limited in this embodiment of this application. As shown in FIG. 14, the apparatus includes:
an obtaining unit 1401, configured to receive second data that includes identification information and that is transmitted by a first module, where the second data is obtained based on an interleaving result obtained by performing convolutional interleaving on symbols included in a plurality of first codewords, the first codeword is a codeword obtained by encoding first data by using a first FEC code, and if the second data includes a second codeword, the identification information includes codeword boundary information of the second codeword, where
the obtaining unit 1401 is further configured to obtain, based on the identification information, to-be-de-interleaved data in the second data and a start interleaving location at which the convolutional interleaving is performed on the symbols included in the plurality of first codewords; and
a de-interleaving unit 1402, configured to perform convolutional de-interleaving on the to-be-de-interleaved data based on the start interleaving location, to obtain the plurality of first codewords.

In a possible implementation, the obtaining unit 1401 is configured to: obtain, based on the codeword boundary information of the second codeword, at least one second codeword included in the second data, obtain a start location of the at least one second codeword, use the start location as the start interleaving location at which the convolutional interleaving is performed on the symbols included in the plurality of first codewords, and decode the at least one second codeword to obtain the to-be-de-interleaved data.

In a possible implementation, if the second data does not include the second codeword, the identification information is frame synchronization information, and the obtaining unit 1401 is configured to: obtain, based on the frame synchronization information, at least one target data frame included in the second data, obtain a start location of frame data of the at least one target data frame, use the start location as the start interleaving location at which the convolutional interleaving is performed on the symbols included in the plurality of first codewords, and use, as the to-be-de-interleaved data, the frame data included in the at least one target data frame.

In a possible implementation, the to-be-de-interleaved data includes a plurality of third bit groups, one third bit group includes symbols that are of the first codewords and that are output by a plurality of first delay units of a convolution interleaver through round robin for one time, and the de-interleaving unit 1402 is configured to: obtain a start de-interleaving location that corresponds to the start interleaving location and that is in a plurality of second delay units of a convolution de-interleaver, input, at the start de-interleaving location, the plurality of third bit groups into the plurality of second delay units, perform, via the plurality of second delay units, convolutional de-interleaving on symbols that are included in the plurality of third bit groups and that are obtained through round robin, obtain the symbols that are included in the plurality of first codewords and that are output by the plurality of second delay units through round robin, and obtain the plurality of first codewords based on the symbols included in the plurality of first codewords.

In a possible implementation, if the second data does not include the second codeword, the identification information indicates the start interleaving location at which the convolutional interleaving is performed on the symbols included in the plurality of first codewords, and the obtaining unit 1401 is configured to: obtain the start interleaving location that is indicated by the identification information and at which the convolutional interleaving is performed on the symbols included in the plurality of first codewords, and use data at the start interleaving location and data after the start interleaving location that are in the second data as the to-be-de-interleaved data.

In a possible implementation, the to-be-de-interleaved data includes a plurality of fourth bit groups; at least one fourth bit group includes symbols that are of the first codewords and that are output by a plurality of first delay units of a convolution interleaver through round robin for one time, or at least one fourth bit group includes identification information and symbols that are output by a plurality of first delay units through round robin for one time; and the de-interleaving unit 1402 is configured to: obtain a start de-interleaving location that corresponds to the start interleaving location and that is in a plurality of second delay units of a convolution de-interleaver, input, at the start de-interleaving location, the plurality of fourth bit groups into the plurality of second delay units, perform, via the plurality of second delay units, convolutional de-interleaving on symbols that are included in the plurality of fourth bit groups and that are obtained through round robin or on identification information and symbols that are included in the plurality of fourth bit groups and that are obtained through round robin, obtain the symbols included in the plurality of first codewords and the identification information that are output by the plurality of second delay units through round robin, and obtain the plurality of first codewords based on the symbols included in the plurality of first codewords.

In a possible implementation, the start de-interleaving location is in any one of the plurality of second delay units.

In a possible implementation, the plurality of second delay units of the convolution de-interleaver output, in a manner of a second data stream, the symbols included in the plurality of first codewords, and a transmission rate of the second data stream is greater than or equal to 100 Gbps.

In a possible implementation, the plurality of second delay units of the convolution de-interleaver output the second data stream through at least one lane of an AUI.

In the apparatus provided in this embodiment of this application, because the second data is obtained by performing convolutional interleaving on the symbols included in the plurality of first codewords, when burst errors occur in the second data, the burst errors are dispersed onto a plurality of symbols, to reduce a BER of the second data after error correction. In addition, if the second data includes the second codeword, the identification information is the codeword boundary information of the second codeword, and no additional identification information indicating the start interleaving location needs to be inserted into the second data, so that data transmission costs are low, applicability to a data transmission scenario in which bandwidth or a frequency of a phase-locked loop is limited is high, and implementation complexity of a data transmission system including the apparatus is low.

It should be understood that, when the apparatuses provided in FIG. 13 and FIG. 14 implements functions of the apparatuses, division of the foregoing functional units is merely used as an example for description. During actual application, the foregoing functions may be allocated to different functional units for implementation based on needs. That is, an internal structure of a device is divided into different functional units to implement all or some of the functions described above. In addition, the apparatuses provided in the foregoing embodiments belong to a same concept as the method embodiments. For specific implementation processes thereof, refer to the method embodiments Details are not described herein again.

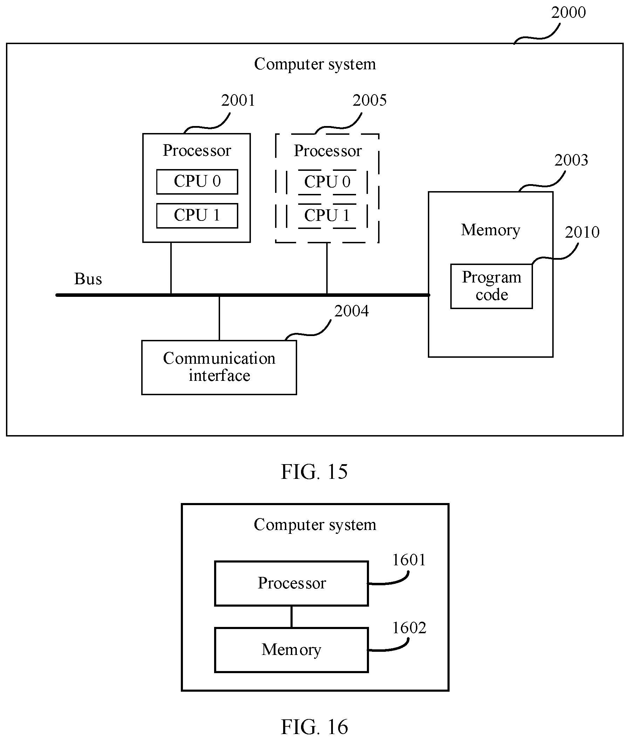

FIG. 15 is a diagram of a structure of a computer system according to an embodiment of this application. For example, as shown in FIG. 15, the computer system is a computer system 2000. The computer system 2000 may be a network device, a routing device, or a switching device. The computer system 2000 shown in FIG. 15 is configured to perform an operation related to the first module or an operation related to the second module in the data transmission method shown in FIG. 8. The computer system 2000 is, for example, a server, and the computer system 2000 may be implemented by a general bus architecture.

As shown in FIG. 15, the computer system 2000 includes at least one processor 2001, a memory 2003, and at least one communication interface 2004.

The processor 2001 is, for example, a central processing unit (central processing unit, CPU), a digital signal processor (digital signal processor, DSP), a network processor (network processor, NP), a graphics processing unit (graphics processing unit, GPU), a neural-network processing unit (neural-network processing unit, NPU), a data processing unit (data processing unit, DPU), a microprocessor, or one or more integrated circuits configured to implement the solutions of this application. For example, the processor 2001 includes an application-specific integrated circuit (application-specific integrated circuit, ASIC), a programmable logic device (programmable logic device, PLD) or another programmable logic device, a transistor logic device, a hardware component, or any combination thereof. The PLD is, for example, a complex programmable logic device (complex programmable logic device, CPLD), a field-programmable gate array (field-programmable gate array, FPGA), a generic array logic (generic array logic, GAL), or any combination thereof. The processor may implement or execute various logical blocks, modules, and circuits described with reference to the content disclosed in embodiments of this application. Alternatively, the processor may be a combination for implementing a computing function, for example, a combination of one or more microprocessors or a combination of the DSP and the microprocessor.

Optionally, the computer system 2000 further includes a bus. The bus is used for information transmission between the components of the computer system 2000. The bus may be a peripheral component interconnect (peripheral component interconnect, PCI) bus, an extended industry standard architecture (extended industry standard architecture, EISA) bus, or the like. Buses may be classified into an address bus, a data bus, a control bus, and the like. For ease of representation, only one bold line is used for representation in FIG. 15, but this does not mean that there is only one bus or only one type of bus.

The memory 2003 is, for example, a read-only memory (read-only memory, ROM) or another type of static storage device that can store static information and instructions, a random access memory (random access memory, RAM) or another type of dynamic storage device that can store information and instructions, an electrically erasable programmable read-only memory (electrically erasable programmable read-only memory, EEPROM), a compact disc read-only memory (compact disc read-only memory, CD-ROM) or another optical disk storage, an optical disc storage (including a compact disc, a laser disc, an optical disc, a digital versatile disc, a Blu-ray disc, or the like), a disk storage medium or another magnetic storage device, or any other medium that can be used to carry or store expected program code in a form of instructions or a data structure and that can be accessed by a computer, but is not limited thereto. For example, the memory 2003 exists independently, and is connected to the processor 2001 through the bus. Alternatively, the memory 2003 may be integrated with the processor 2001.

The communication interface 2004 is any apparatus like a transceiver, and is configured to communicate with another device or a communication network. The communication network may be Ethernet, a radio access network (radio access network, RAN), a wireless local area network (wireless local area network, WLAN), or the like. The communication interface 2004 may include a wired communication interface, and may further include a wireless communication interface. Specifically, the communication interface 2004 may be an Ethernet (Ethernet) interface, a fast Ethernet (fast Ethernet, FE) interface, a gigabit Ethernet (gigabit Ethernet, GE) interface, an asynchronous transfer mode (asynchronous transfer mode, ATM) interface, a WLAN interface, a cellular network communication interface, or a combination thereof. The Ethernet interface may be an optical interface, an electrical interface, or a combination thereof. In this embodiment of this application, the communication interface 2004 may be used by the computer system 2000 to communicate with another device.

During specific implementation, in an embodiment, the processor 2001 may include one or more CPUs such as a CPU 0 and a CPU 1 shown in FIG. 15. Each of the processors may be a single-core (single-CPU) processor or a multi-core (multi-CPU) processor. The processor herein may be one or more devices, circuits, and/or processing cores configured to process data (for example, computer program instructions).

During specific implementation, in an embodiment, the computer system 2000 may include a plurality of processors such as the processor 2001 and a processor 2005 shown in FIG. 15. Each of the processors may be a single-core (single-CPU) processor or a multi-core (multi-CPU) processor. The processor herein may be one or more devices, circuits, and/or processing cores configured to process data (for example, computer program instructions).

During specific implementation, in an embodiment, the computer system 2000 may further include an output device and an input device. The output device communicates with the processor 2001, and may display information in a plurality of manners. For example, the output device may be a liquid crystal display (liquid crystal display, LCD), a light emitting diode (light emitting diode, LED) display device, a cathode ray tube (cathode ray tube, CRT) display device, or a projector (projector). The input device communicates with the processor 2001, and may receive an input of a user in a plurality of manners. For example, the input device may be a mouse, a keyboard, a touchscreen device, or a sensor device.

In some embodiments, the memory 2003 is configured to store program code 2010 for executing the solutions of this application, and the processor 2001 may execute the program code 2010 stored in the memory 2003. The program code 2010 may include one or more software modules. Optionally, the processor 2001 may also store program code or instructions for executing the solutions of this application.

In a specific embodiment, the computer system 2000 in this embodiment of this application may include the first module in the foregoing method embodiments. The processor 2001 in the computer system 2000 reads the program code 2010 in the memory 2003 or the program code or the instructions stored in the processor 2001, to enable the computer system 2000 shown in FIG. 15 to perform all or some of the operations performed by the first module.

In a specific embodiment, the computer system 2000 in this embodiment of this application may include the second module in the foregoing method embodiments. The processor 2001 in the computer system 2000 reads the program code 2010 in the memory 2003 or the program code or the instructions stored in the processor 2001, to enable the computer system 2000 shown in FIG. 15 to perform all or some of the operations performed by the second module.

The computer system 2000 may further correspond to the apparatuses shown in FIG. 13 and FIG. 14. Each functional unit in the apparatuses shown in FIG. 13 and FIG. 14 is implemented by using software of the computer system 2000. In other words, functional units included in the apparatuses shown in FIG. 13 and FIG. 14 are generated after the processor 2001 of the computer system 2000 reads the program code 2010 stored in the memory 2003.

The steps of the data transmission method shown in FIG. 8 are completed by an integrated logic circuit of hardware in the processor of the computer system 2000 or instructions in a form of software. The steps of the method disclosed with reference to embodiments of this application may be directly performed by a hardware processor, or may be performed by a combination of hardware in the processor and a software module. The software module may be located in a mature storage medium in the art, for example, a random access memory, a flash memory, a read-only memory, a programmable read-only memory, an electrically erasable programmable memory, or a register. The storage medium is located in the memory, and the processor reads information in the memory and completes the steps of the foregoing method in combination with the hardware in the processor. To avoid repetition, details are not described herein again.

FIG. 16 is a diagram of a structure of another computer system according to an embodiment of this application. The computer system is configured to perform an operation related to the first module or an operation related to the second module in the data transmission method shown in FIG. 8. For example, the computer system is a server, and the server may vary greatly due to different configurations or performance. The computer system may include one or more processors 1601 and one or more memories 1602. The one or more memories 1602 store at least one computer program, and the at least one computer program is loaded and executed by the one or more processors 1601. For example, the processor 1601 is a CPU. Certainly, the computer system may further include components such as a wired or wireless network interface, a keyboard, and an input/output interface, to perform input/output. The computer system may further include another component configured to implement a device function. Details are not described herein.

An embodiment of this application further provides a computer system. The computer system includes a processor. The processor includes a first module or a second module. The processor is configured to: invoke, from a memory, instructions stored in the memory and run the instructions. If the processor includes the first module, the computer system implements the data transmission method performed by the first module. If the processor includes the second module, the computer system implements the data transmission method performed by the second module.

In a possible implementation, the computer system further includes an input interface, an output interface, and the memory. The input interface, the output interface, the processor, and the memory are connected through an internal connection path.

An embodiment of this application further provides a data transmission system. The data transmission system includes a first module and a second module. The first module is configured to perform the method performed by the first module shown in FIG. 8, and the second module is configured to perform the method performed by the second module shown in FIG. 8. For functions of the first module and the second module in the data transmission system, refer to the related descriptions shown in FIG. 8. Details are not described herein again.

An embodiment of this application further provides a communication apparatus. The apparatus includes a transceiver, a memory, and a processor. The transceiver, the memory, and the processor communicate with each other through an internal connection path. The memory is configured to store instructions. The processor is configured to execute the instructions stored in the memory, to control the transceiver to receive and send a signal. The processor includes a first module or a second module. If the processor includes the first module, when the processor executes the instructions stored in the memory, the processor is enabled to perform the data transmission method performed by the first module. If the processor includes the second module, when the processor executes the instructions stored in the memory, the processor is enabled to perform the data transmission method performed by the second module.

It should be understood that the processor may be a CPU, or may be another general-purpose processor, a DSP, an ASIC, an FPGA or another programmable logic device, a discrete gate or a transistor logic device, a discrete hardware component, or the like. The general-purpose processor may be a microprocessor, any conventional processor, or the like. It should be noted that the processor may be a processor that supports an advanced reduced instruction set computing machine (advanced RISC machine, ARM) architecture.

Further, in an optional embodiment, the memory may include a read-only memory and a random access memory, and provide instructions and data for the processor. The memory may further include a non-volatile random access memory. For example, the memory may further store information about a device type.

The memory may be a volatile memory or a non-volatile memory, or may include both a volatile memory and a non-volatile memory. The non-volatile memory may be a ROM, a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a RAM, and serves as an external cache. By way of example but not limitative description, many forms of RAMs are available, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

An embodiment of this application further provides a computer-readable storage medium. The computer-readable storage medium stores at least one program instruction or code, the program instruction or the code is executed by a computer, and the computer includes a first module or a second module. If the computer includes the first module, when the program instruction or the code is executed by the computer, the computer is enabled to implement the data transmission method performed by the first module. If the computer includes the second module, when the program instruction or the code is executed by the computer, the computer is enabled to implement the data transmission method performed by the second module.

An embodiment of this application further provides a computer program or a computer program product. The computer program or the computer program product includes computer program instructions or code, the computer program instructions or the code is run by a computer, and the computer includes a first module or a second module. If the computer includes the first module, when the computer program instructions or the code is run by the computer, the computer is enabled to perform the data transmission method performed by the first module. If the computer includes the second module, when the computer program instructions or the code is run by the computer, the computer is enabled to perform the data transmission method performed by the second module.

An embodiment of this application further provides a chip, including a processor. The processor includes a first module or a second module, and the processor is configured to run program instructions or code. If the processor includes the first module, a device including the chip performs the data transmission method performed by the first module. If the processor includes the second module, a device including the chip performs the data transmission method performed by the second module.

For example, the chip further includes an input interface, an output interface, and a memory. The input interface, the output interface, the processor, and the memory are connected through an internal connection path. The memory includes the program instructions or the code.

All or some of the foregoing embodiments may be implemented by software, hardware, firmware, or any combination thereof. When the software is used for the implementation, all or some of embodiments may be implemented in a form of a computer program or a computer program product. The computer program or the computer program product includes one or more computer instructions. When the computer program instructions are loaded and executed on a computer, all or some of the procedures or functions according to this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a digital versatile disc (digital video disc, DVD)), a semiconductor medium (for example, a solid-state drive (solid-state drive, SSD)), or the like.

In the foregoing embodiments, a unit of a transmission rate is Gb/s, which may also be referred to as G for short. For example, a rate of 400 Gb/s may also be referred to as 400 G for short.

To clearly describe interchangeability of hardware and software, the steps and compositions of embodiments have been generally described in the foregoing descriptions based on functions. Whether the functions are performed by the hardware or the software depends on a particular application and a design constraint condition of the technical solutions. A person of ordinary skill in the art may use different methods to implement the described functions for each particular application, but it should not be considered that the implementation goes beyond the scope of this application.

Computer program code used to implement the method in embodiments of this application may be written in one or more programming languages. The computer program code may be provided for a processor of a general-purpose computer, a dedicated computer, or another programmable data transmission apparatus, so that when the program code is executed by the computer or another programmable data transmission apparatus, a function/an operation specified in the flowchart and/or the block diagram is implemented. The program code may be executed entirely on a computer, partly on a computer, as a standalone software package, partly on a computer and partly on a remote computer, or entirely on a remote computer or a server.

In the context of embodiments of this application, the computer program code or related data may be carried in any proper carrier, so that the device, the apparatus, or the processor can perform various processing and operations described above. Examples of the carrier include a signal, a computer-readable medium, and the like. Examples of the signal may include an electrical signal, an optical signal, a radio signal, a voice signal, or other forms of propagated signals, such as a carrier wave and an infrared signal.

It may be clearly understood by a person skilled in the art that, for the purpose of convenient and brief description, for detailed working processes of the foregoing described system, device, and module, refer to corresponding processes in the foregoing method embodiments. Details are not described herein again.

In several embodiments provided in this application, it should be understood that the disclosed system, device, and method may be implemented in other manners. For example, the foregoing described device embodiments are merely examples. For example, division into the modules is merely logical function division and may be other division in actual implementation. For example, a plurality of modules or components may be combined or integrated into another system, or some features may be ignored or not performed. In addition, the displayed or discussed mutual couplings or direct couplings or communication connections may be implemented through some interfaces. The indirect couplings or communication connections between the devices or modules may be implemented in electrical, mechanical, or other forms.

The modules described as separate parts may or may not be physically separate, and parts displayed as modules may or may not be physical modules, that is, may be located in one position, or may be distributed on a plurality of network modules. Some or all of the modules may be selected based on actual needs to achieve the objectives of the solutions of embodiments of this application.

In addition, functional modules in embodiments of this application may be integrated into one processing module, each of the modules may exist alone physically, or two or more modules may be integrated into one module. The integrated module may be implemented in a form of hardware, or may be implemented in a form of a software functional module.

In this application, terms such as "first" and "second" are used to distinguish between same items or similar items that have basically same functions. It should be understood that there is no logical or time sequence dependency between "first", "second", and "n^{th}", and a quantity and an execution sequence are not limited. It should be further understood that although the following descriptions use terms such as first and second to describe various elements, these elements should not be limited by the terms. These terms are merely used to distinguish one element from another. For example, the first module may be referred to as the second module without departing from the scope of the various examples, and similarly, the second module may be referred to as the first module.

It should be further understood that sequence numbers of the processes do not mean execution sequences in embodiments of this application. The execution sequences of the processes should be determined based on functions and internal logic of the processes, and should not constitute any limitation on implementation processes of embodiments of this application.

In this application, the term "at least one" means one or more, and the term "a plurality of" in this application means two or more. For example, a plurality of code blocks mean two or more code blocks. The terms "system" and "network" are often used interchangeably in this specification.

It should be understood that the terms used in the descriptions of the various examples in this specification are merely intended to describe specific examples but are not intended to constitute a limitation. For example, "a ("a" and "an")" and "the" of singular forms used in the descriptions of the various examples and the appended claims are intended to include plural forms, unless otherwise specified in the context clearly.

It should be further understood that the term "include" (also referred to as "includes", "including", "comprises", and/or "comprising") used in this specification specifies presence of the stated features, integers, steps, operations, elements, and/or components, with presence or addition of one or more other features, integers, steps, operations, elements, components, and/or combinations thereof not excluded.

It should be further understood that, depending on the context, the phrase "if it is determined that" or "if [a stated condition or event] is detected" may be interpreted as a meaning of "when it is determined that", "in response to determining that", "when [the stated condition or event] is detected", or "in response to detecting [the stated condition or event]".

It should be understood that determining B based on A does not mean that B is determined based only on A. B may alternatively be determined based on A and/or other information.

It should be further understood that "one embodiment", "an embodiment", and "a possible implementation" mentioned throughout the specification mean that particular features, structures, or characteristics related to the embodiment or the implementation are included in at least one embodiment of this application. Therefore, "in one embodiment", "in an embodiment", or "a possible implementation" appearing throughout the specification may not necessarily refer to a same embodiment. In addition, these particular features, structures, or characteristics may be combined in one or more embodiments in any appropriate manner.

## Claims

1. A data transmission method, wherein the method comprises:
performing, by a first module, convolutional interleaving on symbols comprised in a plurality of obtained first codewords, to obtain an interleaving result, wherein the first codeword is obtained by encoding first data by using a first forward error correction FEC code;
obtaining, based on the interleaving result, second data that comprises identification information, wherein when the second data comprises a second codeword, the identification information comprises codeword boundary information of the second codeword; and
transmitting the second data to a second module.

2. The method according to claim 1, wherein the performing convolutional interleaving on symbols comprised in a plurality of obtained first codewords, to obtain an interleaving result comprises:
inputting the symbols comprised in the plurality of first codewords into a plurality of first delay units of a convolution interleaver, and performing, via the plurality of first delay units, convolutional interleaving on the symbols that are comprised in the plurality of first codewords and that are obtained through round robin, to obtain a plurality of first bit groups that are output by the plurality of first delay units through round robin, wherein one first bit group comprises symbols that are output by the plurality of first delay units through round robin for one time; and
using, as the interleaving result, the plurality of first bit groups that are output by the plurality of first delay units through round robin.

3. The method according to claim 2, wherein the interleaving result comprises n first bit groups that are output by the plurality of first delay units through round robin for n times, and the obtaining, based on the interleaving result, second data that comprises identification information comprises:
encoding, based on a second FEC code, the n first bit groups that are output by the plurality of first delay units through round robin for n times, to obtain m second codewords, wherein a quantity of bits corresponding to the n first bit groups is equal to a quantity of bits comprised in information bits of the m codewords of the second FEC code, both m and n are positive integers, and m is less than or equal to n; and
obtaining the second data based on the m second codewords.

4. The method according to claim 2, wherein the second data does not comprise the second codeword, the interleaving result comprises n first bit groups that are output by the plurality of first delay units through round robin for n times, and the obtaining, based on the interleaving result, second data that comprises identification information comprises:
obtaining k target data frames based on a format of a reference data frame and the n first bit groups that are output by the plurality of first delay units through round robin for n times, wherein the target data frame comprises frame synchronization information, the frame synchronization information is used as the identification information, a quantity of bits corresponding to the n first bit groups is less than or equal to a quantity of bits comprised in the k target data frames, both k and n are positive integers, and k is less than or equal to n; and
obtaining the second data based on the k target data frames.

5. The method according to claim 1, wherein the second data does not comprise the second codeword, and the performing convolutional interleaving on symbols comprised in a plurality of obtained first codewords, to obtain an interleaving result comprises:
inputting at least one piece of identification information and the symbols comprised in the plurality of first codewords into a plurality of first delay units of a convolution interleaver, and performing, via the plurality of first delay units, convolutional interleaving on the at least one piece of identification information that is obtained through round robin and the symbols that are comprised in the plurality of first codewords and that are obtained through round robin, to obtain a plurality of second bit groups that are output by the plurality of first delay units through round robin, wherein at least one second bit group comprises symbols that are output by the plurality of first delay units through round robin for one time, or at least one second bit group comprises identification information and symbols that are output by the plurality of first delay units through round robin for one time, and the identification information indicates a start interleaving location at which the convolutional interleaving is performed on the symbols comprised in the plurality of first codewords; and
using, as the interleaving result, the plurality of second bit groups that are output by the plurality of first delay units through round robin.

6. The method according to any one of claims 2 to 5, wherein the start interleaving location at which the convolutional interleaving is performed on the symbols comprised in the plurality of first codewords is in any one of the plurality of first delay units.

7. The method according to any one of claims 2 to 6, wherein the symbols comprised in the plurality of first codewords are input into the plurality of first delay units of the convolution interleaver in a manner of a first data stream, and a transmission rate of the first data stream is greater than or equal to 100 gigabits per second.

8. The method according to claim 7, wherein the first data stream is transmitted to the plurality of first delay units of the convolution interleaver through at least one lane of an attachment unit interface AUI.

9. A data transmission method, wherein the method comprises:
receiving, by a second module, second data that comprises identification information and that is transmitted by a first module, wherein the second data is obtained based on an interleaving result obtained by performing convolutional interleaving on symbols comprised in a plurality of first codewords, the first codeword is obtained by encoding first data by using a first forward error correction FEC code, and when the second data comprises a second codeword, the identification information comprises codeword boundary information of the second codeword;
obtaining, based on the identification information, to-be-de-interleaved data in the second data and a start interleaving location at which the convolutional interleaving is performed on the symbols comprised in the plurality of first codewords; and
performing convolutional de-interleaving on the to-be-de-interleaved data based on the start interleaving location, to obtain the plurality of first codewords.

10. The method according to claim 9, wherein the obtaining, based on the identification information, to-be-de-interleaved data in the second data and a start interleaving location at which the convolutional interleaving is performed on the symbols comprised in the plurality of first codewords comprises:
obtaining, based on the codeword boundary information of the second codeword, at least one second codeword comprised in the second data;
obtaining a start location of the at least one second codeword, and using the start location as the start interleaving location at which the convolutional interleaving is performed on the symbols comprised in the plurality of first codewords; and
decoding the at least one second codeword to obtain the to-be-de-interleaved data.

11. The method according to claim 9, wherein if the second data does not comprise the second codeword, the identification information is frame synchronization information, and the obtaining, based on the identification information, to-be-de-interleaved data in the second data and a start interleaving location at which the convolutional interleaving is performed on the symbols comprised in the plurality of first codewords comprises:
obtaining, based on the frame synchronization information, at least one target data frame comprised in the second data;
obtaining a start location of frame data of the at least one target data frame, and using the start location as the start interleaving location at which the convolutional interleaving is performed on the symbols comprised in the plurality of first codewords; and
using, as the to-be-de-interleaved data, the frame data comprised in the at least one target data frame.

12. The method according to claim 10 or 11, wherein the to-be-de-interleaved data comprises a plurality of third bit groups, one third bit group comprises symbols that are of the first codewords and that are output by a plurality of first delay units of a convolution interleaver through round robin for one time, and the performing convolutional de-interleaving on the to-be-de-interleaved data based on the start interleaving location, to obtain the plurality of first codewords comprises:
obtaining a start de-interleaving location that corresponds to the start interleaving location and that is in a plurality of second delay units of a convolution de-interleaver;
inputting, at the start de-interleaving location, the plurality of third bit groups into the plurality of second delay units, and performing, via the plurality of second delay units, convolutional de-interleaving on symbols that are comprised in the plurality of third bit groups and that are obtained through round robin; and
obtaining the symbols that are comprised in the plurality of first codewords and that are output by the plurality of second delay units through round robin, and obtaining the plurality of first codewords based on the symbols comprised in the plurality of first codewords.

13. The method according to claim 9, wherein if the second data does not comprise the second codeword, the identification information indicates the start interleaving location at which the convolutional interleaving is performed on the symbols comprised in the plurality of first codewords; and
the obtaining, based on the identification information, to-be-de-interleaved data in the second data and a start interleaving location at which the convolutional interleaving is performed on the symbols comprised in the plurality of first codewords comprises:
obtaining the start interleaving location that is indicated by the identification information and at which the convolutional interleaving is performed on the symbols comprised in the plurality of first codewords; and
using data at the start interleaving location and data after the start interleaving location that are in the second data as the to-be-de-interleaved data.

14. The method according to claim 13, wherein the to-be-de-interleaved data comprises a plurality of fourth bit groups, and at least one fourth bit group comprises symbols that are of the first codewords and that are output by a plurality of first delay units of a convolution interleaver through round robin for one time, or at least one fourth bit group comprises identification information and symbols that are output by a plurality of first delay units through round robin for one time; and
the performing convolutional de-interleaving on the to-be-de-interleaved data based on the start interleaving location, to obtain the plurality of first codewords comprises:
obtaining a start de-interleaving location that corresponds to the start interleaving location and that is in a plurality of second delay units of a convolution de-interleaver;
inputting, at the start de-interleaving location, the plurality of fourth bit groups into the plurality of second delay units, and performing, via the plurality of second delay units, convolutional de-interleaving on symbols that are comprised in the plurality of fourth bit groups and that are obtained through round robin or on identification information and symbols that are comprised in the plurality of fourth bit groups and that are obtained through round robin; and
obtaining the symbols comprised in the plurality of first codewords and the identification information that are output by the plurality of second delay units through round robin, and obtaining the plurality of first codewords based on the symbols comprised in the plurality of first codewords.

15. The method according to claim 12 or 14, wherein the start de-interleaving location is in any one of the plurality of second delay units.

16. The method according to any one of claims 12, 14, and 15, wherein the plurality of second delay units of the convolution de-interleaver output, in a manner of a second data stream, the symbols comprised in the plurality of first codewords, and a transmission rate of the second data stream is greater than or equal to 100 gigabits per second.

17. The method according to claim 16, wherein the plurality of second delay units of the convolution de-interleaver output the second data stream through at least one lane of an attachment unit interface AUI.

18. A data transmission apparatus, wherein the apparatus is used in a first module, and the apparatus comprises:
an interleaving unit, configured to perform convolutional interleaving on symbols comprised in a plurality of obtained first codewords, to obtain an interleaving result, wherein the first codeword is obtained by encoding first data by using a first forward error correction FEC code;
an obtaining unit, configured to obtain, based on the interleaving result, second data that comprises identification information, wherein when the second data comprises a second codeword, the identification information comprises codeword boundary information of the second codeword; and
a transmission unit, configured to transmit the second data to a second module.

19. The apparatus according to claim 18, wherein the interleaving unit is configured to: input the symbols comprised in the plurality of first codewords into a plurality of first delay units of a convolution interleaver; perform, via the plurality of first delay units, convolutional interleaving on the symbols that are comprised in the plurality of first codewords and that are obtained through round robin, to obtain a plurality of first bit groups that are output by the plurality of first delay units through round robin, wherein one first bit group comprises symbols that are output by the plurality of first delay units through round robin for one time; and use, as the interleaving result, the plurality of first bit groups that are output by the plurality of first delay units through round robin.

20. The apparatus according to claim 19, wherein the interleaving result comprises n first bit groups that are output by the plurality of first delay units through round robin for n times, and the obtaining unit is configured to: encode, based on a second FEC code, the n first bit groups that are output by the plurality of first delay units through round robin for n times, to obtain m second codewords, wherein a quantity of bits corresponding to the n first bit groups is equal to a quantity of bits comprised in information bits of the m codewords of the second FEC code, both m and n are positive integers, and m is less than or equal to n; and obtain the second data based on the m second codewords.

21. The apparatus according to claim 19, wherein the second data does not comprise the second codeword, the interleaving result comprises n first bit groups that are output by the plurality of first delay units through round robin for n times, and the obtaining unit is configured to: obtain k target data frames based on a format of a reference data frame and the n first bit groups that are output by the plurality of first delay units through round robin for n times, wherein the target data frame comprises frame synchronization information, the frame synchronization information is used as the identification information, a quantity of bits corresponding to the n first bit groups is less than or equal to a quantity of bits comprised in the k target data frames, both k and n are positive integers, and k is less than or equal to n; and obtain the second data based on the k target data frames.

22. The apparatus according to claim 18, wherein the second data does not comprise the second codeword, and the interleaving unit is configured to: input at least one piece of identification information and the symbols comprised in the plurality of first codewords into a plurality of first delay units of a convolution interleaver; perform, via the plurality of first delay units, convolutional interleaving on the at least one piece of identification information that is obtained through round robin and the symbols that are comprised in the plurality of first codewords and that are obtained through round robin, to obtain a plurality of second bit groups that are output by the plurality of first delay units through round robin, wherein at least one second bit group comprises symbols that are output by the plurality of first delay units through round robin for one time, or at least one second bit group comprises identification information and symbols that are output by the plurality of first delay units through round robin for one time, and the identification information indicates a start interleaving location at which the convolutional interleaving is performed on the symbols comprised in the plurality of first codewords; and use, as the interleaving result, the plurality of second bit groups that are output by the plurality of first delay units through round robin.

23. The apparatus according to any one of claims 19 to 22, wherein the start interleaving location at which the convolutional interleaving is performed on the symbols comprised in the plurality of first codewords is in any one of the plurality of first delay units.

24. The apparatus according to any one of claims 19 to 23, wherein the symbols comprised in the plurality of first codewords are input into the plurality of first delay units of the convolution interleaver in a manner of a first data stream, and a transmission rate of the first data stream is greater than or equal to 100 gigabits per second.

25. The apparatus according to claim 24, wherein the first data stream is transmitted to the plurality of first delay units of the convolution interleaver through at least one lane of an attachment unit interface AUI.

26. A data transmission apparatus, wherein the apparatus is used in a second module, and the apparatus comprises:
an obtaining unit, configured to receive second data that comprises identification information and that is transmitted by a first module, wherein the second data is obtained based on an interleaving result obtained by performing convolutional interleaving on symbols comprised in a plurality of first codewords, the first codeword is obtained by encoding first data by using a first forward error correction FEC code, and when the second data comprises a second codeword, the identification information comprises codeword boundary information of the second codeword, wherein
the obtaining unit is further configured to obtain, based on the identification information, to-be-de-interleaved data in the second data and a start interleaving location at which the convolutional interleaving is performed on the symbols comprised in the plurality of first codewords; and
a de-interleaving unit, configured to perform convolutional de-interleaving on the to-be-de-interleaved data based on the start interleaving location, to obtain the plurality of first codewords.

27. The apparatus according to claim 26, wherein the obtaining unit is configured to: obtain, based on the codeword boundary information of the second codeword, at least one second codeword comprised in the second data, obtain a start location of the at least one second codeword, use the start location as the start interleaving location at which the convolutional interleaving is performed on the symbols comprised in the plurality of first codewords, and decode the at least one second codeword to obtain the to-be-de-interleaved data.

28. The apparatus according to claim 26, wherein if the second data does not comprise the second codeword, the identification information is frame synchronization information, and the obtaining unit is configured to: obtain, based on the frame synchronization information, at least one target data frame comprised in the second data, obtain a start location of frame data of the at least one target data frame, use the start location as the start interleaving location at which the convolutional interleaving is performed on the symbols comprised in the plurality of first codewords, and use, as the to-be-de-interleaved data, the frame data comprised in the at least one target data frame.

29. The apparatus according to claim 27 or 28, wherein the to-be-de-interleaved data comprises a plurality of third bit groups, one third bit group comprises symbols that are of the first codewords and that are output by a plurality of first delay units of a convolution interleaver through round robin for one time, and the de-interleaving unit is configured to: obtain a start de-interleaving location that corresponds to the start interleaving location and that is in a plurality of second delay units of a convolution de-interleaver, input, at the start de-interleaving location, the plurality of third bit groups into the plurality of second delay units, perform, via the plurality of second delay units, convolutional de-interleaving on the symbols that are comprised in the plurality of third bit groups and that are obtained through round robin, obtain the symbols that are comprised in the plurality of first codewords and that are output by the plurality of second delay units through round robin, and obtain the plurality of first codewords based on the symbols comprised in the plurality of first codewords.

30. The apparatus according to claim 26, wherein if the second data does not comprise the second codeword, the identification information indicates the start interleaving location at which the convolutional interleaving is performed on the symbols comprised in the plurality of first codewords, and the obtaining unit is configured to: obtain the start interleaving location that is indicated by the identification information and at which the convolutional interleaving is performed on the symbols comprised in the plurality of first codewords, and use data at the start interleaving location and data after the start interleaving location that are in the second data as the to-be-de-interleaved data.

31. The apparatus according to claim 30, wherein the to-be-de-interleaved data comprises a plurality of fourth bit groups, at least one fourth bit group comprises symbols that are of the first codewords and that are output by a plurality of first delay units of a convolution interleaver through round robin for one time, or at least one fourth bit group comprises identification information and symbols that are output by a plurality of first delay units through round robin for one time; and the de-interleaving unit is configured to: obtain a start de-interleaving location that corresponds to the start interleaving location and that is in a plurality of second delay units of a convolution de-interleaver, input, at the start de-interleaving location, the plurality of fourth bit groups into the plurality of second delay units, perform, via the plurality of second delay units, convolutional de-interleaving on symbols that are comprised in the plurality of fourth bit groups and that are obtained through round robin or on identification information and symbols that are comprised in the plurality of fourth bit groups and that are obtained through round robin, obtain the symbols comprised in the plurality of first codewords and the identification information that are output by the plurality of second delay units through round robin, and obtain the plurality of first codewords based on the symbols comprised in the plurality of first codewords.

32. The apparatus according to claim 29 or 31, wherein the start de-interleaving location is in any one of the plurality of second delay units.

33. The apparatus according to any one of claims 29, 31, and 32, wherein the plurality of second delay units of the convolution de-interleaver output, in a manner of a second data stream, the symbols comprised in the plurality of first codewords, and a transmission rate of the second data stream is greater than or equal to 100 gigabits per second.

34. The apparatus according to claim 33, wherein the plurality of second delay units of the convolution de-interleaver output the second data stream through at least one lane of an attachment unit interface AUI.

35. A data transmission system, wherein the data transmission system comprises a first module and a second module, the first module is configured to perform the method according to any one of claims 1 to 8, and the second module is configured to perform the method according to any one of claims 9 to 17.

36. A computer system, wherein the computer system comprises a processor, the processor comprises a first module or a second module, and if the processor comprises the first module, when the processor executes program instructions or code, the computer system implements the method according to any one of claims 1 to 8, or if the processor comprises the second module, when the processor executes program instructions or code, the computer system implements the method according to any one of claims 9 to 17.

37. The computer system according to claim 36, wherein the computer system further comprises a memory, and the memory is configured to store the program instructions or the code.

38. A computer-readable storage medium, wherein the computer-readable storage medium stores at least one program instruction or code, the program instruction or the code is executed by a computer, the computer comprises a first module or a second module, and if the computer comprises the first module, when the program instruction or the code is executed by the computer, the computer is enabled to implement the method according to any one of claims 1 to 8, or if the computer comprises the second module, when the program instruction or the code is executed by the computer, the computer is enabled to implement the method according to any one of claims 9 to 17.

39. A computer program product, wherein the computer program product comprises computer program instructions or code, the computer program instructions or the code is run by a computer, the computer comprises a first module or a second module, and if the computer comprises the first module, when the computer program instructions or the code is run by the computer, the computer is enabled to implement the method according to any one of claims 1 to 8, or if the computer comprises the second module, when the computer program instructions or the code is run by the computer, the computer is enabled to implement the method according to any one of claims 9 to 17.

40. A chip, wherein the chip comprises a processor, the processor comprises a first module or a second module, the processor is configured to run program instructions or code, and if the processor comprises the first module, a device comprising the chip performs the method according to any one of claims 1 to 8, or if the processor comprises the second module, a device comprising the chip performs the method according to any one of claims 9 to 17.

41. The chip according to claim 40, wherein the chip further comprises an input interface, an output interface, and a memory, the input interface, the output interface, the processor, and the memory are connected through an internal connection path, and the memory comprises the program instructions or the code.
